(19) **Europäisches Patentamt / European Patent Office / Office européen des brevets**

(11) **EP 4 595 233 B1**

(12) **FASCICULE DE BREVET EUROPEEN**

(45) Date de publication et mention de la délivrance du brevet:
**22.10.2025   Bulletin 2025/43**

(21) Numéro de dépôt: **24809574.7**

(22) Date de dépôt: **13.11.2024**

(51) Classification Internationale des Brevets (IPC):
**H03M 13/11** *(2006.01)*     **H03M 13/00** *(2006.01)*
**H04L 1/00** *(2006.01)*

(52) Classification Coopérative des Brevets (CPC):
**H03M 13/1137; H03M 13/114; H03M 13/116; H03M 13/6502; H03M 13/6516; H03M 13/6561; H04L 1/005; H04L 1/0057**

(86) Numéro de dépôt international:
**PCT/EP2024/082265**

(87) Numéro de publication internationale:
**WO 2025/108816 (30.05.2025 Gazette 2025/22)**

(54) **DÉCODEUR LDPC AVEC UNE ARCHITECTURE MULTICOEUR**

LDPC-DECODIERER MIT MEHRKERNARCHITEKTUR

LDPC DECODER WITH MULTI-CORE ARCHITECTURE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **24.11.2023   FR 2312667**

(43) Date de publication de la demande:
**06.08.2025   Bulletin 2025/32**

(73) Titulaire: **Airbus Defence and Space SAS**
**31402 Toulouse Cedex 4 (FR)**

(72) Inventeurs:
• **BARTHE, Lyonel**
  **31402 Toulouse Cedex 04 (FR)**
• **GADAT, Benjamin**
  **31402 Toulouse Cedex 04 (FR)**

(74) Mandataire: **Ipside**
**6, Impasse Michel Labrousse**
**31100 Toulouse (FR)**

(56) Documents cités:
**EP-B1- 3 331 180     US-A1- 2022 182 076**

• **XIN-YU SHIH ET AL: "A real-time programmable LDPC decoder chip for arbitrary QC-LDPC parity check matrices", SOLID-STATE CIRCUITS CONFERENCE, 2009. A-SSCC 2009. IEEE ASIAN, IEEE, PISCATAWAY, NJ, USA, 16 November 2009 (2009-11-16), pages 369 - 372, XP031582921, ISBN: 978-1-4244-4433-5**
• **JIN ZUOLIN ET AL: "Low Latency MCS Design for LEO Satellite Communication Based on 5G", 2022 IEEE 22ND INTERNATIONAL CONFERENCE ON COMMUNICATION TECHNOLOGY (ICCT), IEEE, 11 November 2022 (2022-11-11), pages 1432 - 1436, XP034316663, [retrieved on 20230327], DOI: 10.1109/ICCT56141.2022.10072450**
• **FOMINYKH A A ET AL: "Comparative Analysis of Polar and LDPC Codes in Space and Satellite Communication Systems", 2023 WAVE ELECTRONICS AND ITS APPLICATION IN INFORMATION AND TELECOMMUNICATION SYSTEMS (WECONF), IEEE, 29 May 2023 (2023-05-29), pages 1 - 4, XP034359771, DOI: 10.1109/WECONF57201.2023.10148035**
• **ZHAO QIANGYI ET AL: "Design of a Multi-Core Scheduling Scheme for Tera-bit/s LDPC Decoding", 2019 28TH WIRELESS AND OPTICAL COMMUNICATIONS CONFERENCE (WOCC), IEEE, 9 May 2019 (2019-05-09), pages 1 - 5, XP033581441, DOI: 10.1109/WOCC.2019.8770608**

EP 4 595 233 B1

## Description

### Domaine de l'invention

La présente invention appartient au domaine des codes de contrôle de parité à faible densité (LDPC, pour « Low Density Parity Check »). Notamment, l'invention concerne une architecture multicœur pour un décodeur LDPC.

### Etat de la technique

Les codes LDPC sont actuellement utilisés dans plusieurs technologies de communication, notamment pour les normes IEEE 802.16 (WiMAX), IEE 802.11n (Wi-Fi), le standard 5G de l'organisme 3GPP (« 3rd Generation Partnership Project »), le standard DVB-S2 (« Digital Video Broadcasting, 2nd Generation »), ou le standard de communications spatiales CCSDS C2 (« Consultative Committee for Space Data Systems, C2 »).

Un code LDPC binaire est un code correcteur d'erreurs linéaire défini par une matrice de parité binaire de faible densité (c'est-à-dire que le nombre d'éléments non nuls de la matrice est relativement faible par rapport à la taille de la matrice).

Pour réduire la complexité d'implémentation matérielle d'un décodeur LDPC, il est connu d'utiliser des structures particulières de la matrice de parité. En particulier, les codes LDPC quasi-cycliques (QC-LDPC pour « Quasi-Cyclic Low Density Parity Check ») sont définis par des matrices de parité composée de sous-matrices de taille $Z \times Z$. Le terme $Z$ est généralement appelé « facteur d'expansion ». Les sous-matrices de taille $Z \times Z$ sont généralement appelées « matrices circulantes ». Une matrice de parité d'un code QC-LDPC présente une structure en couches qui permet de paralléliser les calculs des messages de contrôle de parité au sein d'une couche.

Le document de spécification technique 3GPP TS 38.212 décrit les configurations LDPC qui doivent être supportées par un dispositif compatible avec le standard 5G.

Ces codes LDPC 5G sont compatibles en termes de taux de codage pour la retransmission à redondance incrémentale (IR-HARQ pour « Incremental Redundancy Hybrid Automatic ReQuest » en anglais). L'HARQ est une technique qui permet de retransmettre des données qui ont été corrompues par le canal de communication. Dans la variante « Chase Combining » (CC-HARQ), le même taux de codage est utilisé à chaque retransmission. Dans la variante IR-HARQ, un taux de codage différent est utilisé à chaque retransmission.

Les codes LDPC 5G sont basés sur des matrices de parité quasi-cycliques. Chaque configuration LDPC 5G correspond à un triplet de paramètres comprenant la taille K du mot encodé (c'est le nombre de bits utiles dans le mot de code LDPC), le taux de codage R (cela correspond sensiblement au rapport K/N entre la taille K du mot encodé et la taille N du mot de code LDPC) et le facteur d'expansion Z. En définissant les paramètres K et R, on peut en déduire le paramètre Z à utiliser, puis construire dynamiquement la matrice de parité à utiliser.

Un très grand nombre (plusieurs milliers) de configurations différentes sont supportées par la spécification (K peut varier de quelques bits à plusieurs milliers de bits, Z peut prendre une cinquantaine de valeurs possibles, et un grand nombre de taux de codage R sont supportés). Cela rend les codes LDPC 5G très flexibles et adaptables à un très large éventail de conditions de transmission.

Cette ultra-flexibilité des codes LDPC entraine toutefois une complexité très importante des décodeurs les mettant en œuvre. En outre, les décodeurs LDPC 5G conventionnels sont généralement peu efficaces pour des transmissions utilisant une bande spectrale fixe. La grande flexibilité sur le facteur d'expansion Z entraine une complexité du réseau de permutation de l'architecture en couches. Cette complexité augmente l'empreinte des registres et des portes logiques du circuit. Cette complexité entraine également une réduction du débit global du décodeur. En outre, l'architecture parallèle d'un décodeur LDPC 5G conventionnel est souvent sous-optimale pour des valeurs du facteur d'expansion Z peu élevées.

Les contraintes relatives au domaine spatial (contraintes en termes d'encombrement, de poids et de consommation énergétique notamment) font que les décodeurs LDPC 5G conventionnels ne sont pas adaptés pour être embarqués à bord d'un satellite.

La demande de brevet US 2022/182076 A1 décrit un décodeur LDPC comportant un décodeur principal (« *full range decoder* ») et un ou plusieurs décodeurs auxiliaires (« *auxiliary decoders* »). Les mots de code pour lesquels le facteur d'expansion est supérieur à un seuil prédéfini sont décodés par le décodeur principal, tandis que les mots de code pour lesquels le facteur d'expansion est inférieur au seuil sont décodés par les décodeurs auxiliaires. Le document « Comparative Analysis of Polar and LDPC Codes in Space and Satellite Communication Systems », Fominykh A. et al., concerne l'utilisation de codes LDPC dans les communications satellitaires. Le document « Design of a Multi-Core Scheduling Scheme for Tera-bit/s LDPC Decoding », Zhao Qiangyi et al., présente une architecture multicœur pour un décodeur LDPC.

Le document « A real-time programmable LDPC decoder chip for arbitrary QC-LDPC parity check matrices », Sin-Yu Shih et al., décrit un décodeur LDPC reconfigurable à la volée.

Le document « Low Latency MCS Design for LEO Satellite Communication Based on 5G », Jin Zuolin et al., décrit différents schémas de codage et de modulation pour un système de communication par satellites LEO basé sur la 5G.

Le document « Design of a Multi-Core Scheduling Scheme for Tera-bits/s LDPC Decoding », Zhao Qiangyi et al., décrit un schéma d'ordonnancement pour un décode LDPC multi-cœurs.

Le brevet EP 3 331 180 B1 divulgue une méthode et un dispositif de décodage FEC ( « Forward Error Correction », en français « correction d'erreur directe ») à utiliser dans le domaine des télécommunications, en particulier pour un élément de réseau d'un réseau de communication avec multiplexage en longueur d'onde (WDM pour « Wavelength Division Multiplexing »).

La demande de brevet EP 2 369 749 A2 décrit un décodeur LDPC flexible pouvant être mis en œuvre avec un niveau de parallélisme inférieur au parallélisme total de la structure de code utilisée pour contrôler le processus de décodage.

Le brevet US 11 108 410 B1 décrit un décodeur LDPC programmable qui peut être configuré pour prendre en charge une large gamme de codes LDPC.

**Exposé de l'invention**

La présente invention a pour objectif de remédier à tout ou partie des inconvénients de l'art antérieur.

A cet effet, et selon un premier aspect, il est proposé par la présente invention un décodeur LDPC multicœur pour le décodage de mots de code de contrôle de parité de faible densité, ou code LDPC, selon la revendication 1.

Cette approche multicœur est particulièrement avantageuse puisqu'elle permet le décodage de plusieurs mots de code en parallèle. Ainsi, à un instant donné, différents mots de code peuvent être décodés en parallèle par différents cœurs selon

différentes configurations. L'approche multicœur permet également d'optimiser les besoins en ressource mémoire, via un partage de mémoire entre tous les cœurs d'un même groupe.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, les $N_C$ configurations prédéfinies forment un sous-groupe, au sens strict, des configurations LDPC 5G définies dans le standard 3GPP TS 38.212.

Dans des modes particuliers de réalisation, chaque cœur comporte une mémoire locale de configuration dont la taille est au moins égale à la plus grande des tailles des $N_C$ configurations prédéfinies mémorisées dans la mémoire partagée, et la taille de la mémoire locale est au moins quatre fois plus petite que la taille de la mémoire partagée.

Plus le rapport entre la taille de la mémoire locale d'un cœur et la taille de la mémoire partagée entre les différents cœurs d'un même groupe est petit, et plus le partage de la mémoire entre les différents cœurs est efficace.

Dans des modes particuliers de réalisation, le nombre $N_C$ de configurations prédéfinies mémorisées dans la mémoire partagée est compris entre 8 et 512, voire entre 8 et 256, voire même entre 8 et 128.

En sélectionnant un nombre restreint de configurations LDPC, il est possible de précalculer et de mémoriser les matrices de parité correspondant aux configurations sélectionnées. Il n'est alors plus nécessaire de construire dynamiquement la matrice de parité à chaque fois qu'un mot de code doit être décodé avec une nouvelle configuration LDPC. Cela permet également d'optimiser les ressources matérielles du décodeur, notamment en termes de besoin en mémoire, mais aussi en termes de complexité matérielle au niveau des multiplexeurs et du réseau de permutation, et en termes de consommation énergétique. Cela peut également permettre d'optimiser l'ordonnancement des nœuds de contrôle de parité pour chaque configuration, afin de maximiser les performances du décodeur.

Dans des modes particuliers de réalisation, chacune des $N_C$ configurations comporte un ordonnancement optimisé de nœuds de contrôle de parité du cœur. L'ordonnancement est défini en fonction d'un degré de parité de chaque nœud de contrôle de parité pour la configuration considérée.

De telles dispositions permettent de limiter les situations où certains nœuds de contrôle ne peuvent pas être exécutés parce que les données en sortie d'autres nœuds de contrôle ne sont pas disponibles. Autrement dit, cela permet de limiter la perte de performance liée aux « aléas de données » (« data hazards » en anglais) : le nombre de cycles d'attente dans le processus de décodage est plus faible, et le débit global du décodeur est amélioré.

Dans des modes particuliers de réalisation, le décodage d'un mot de code LDPC par un cœur comporte l'exécution d'une ou plusieurs itérations jusqu'à ce qu'un critère d'arrêt soit satisfait. Le critère d'arrêt comporte une vérification si un nombre maximal d'itérations est atteint et, pour un nouveau mot de code à décoder par un cœur, le nombre maximal d'itérations est défini en fonction d'un taux de charge du décodeur multicœur.

Il est avantageux d'avoir un nombre maximal d'itérations plus faible lorsque le taux de charge du décodeur multicœur est important. En effet, quand le taux de charge du décodeur est important, il est avantageux de libérer rapidement les cœurs pour pouvoir décoder de nouveaux mots de code.

Dans des modes particuliers de réalisation, le taux de charge à un instant donné est calculé en fonction d'un nombre de cœurs simultanément occupés à décoder un mot de code LDPC audit instant.

Dans des modes particuliers de réalisation, le nombre maximal d'itérations est défini aussi en fonction de la taille du nouveau mot de code.

Dans des modes particuliers de réalisation, le nombre maximal d'itérations est défini aussi en fonction d'un taux de codage utilisé pour le nouveau mot de code.

Dans des modes particuliers de réalisation, le nombre maximal d'itérations est défini aussi en fonction d'un rapport signal sur bruit estimé pour le nouveau mot de code.

Dans des modes particuliers de réalisation, le décodeur multicœur comporte un module d'ordonnancement adapté pour ordonnancer les cœurs en favorisant, pour le décodage d'un nouveau mot de code, la sélection d'un cœur pour lequel la dernière configuration utilisée par le cœur pour le décodage d'un mot de code précédent est la même que la configuration devant être utilisée pour le décodage du nouveau mot de code.

De telles dispositions peuvent permettre d'éviter d'avoir à recharger une nouvelle configuration dans la mémoire locale d'un cœur pour le décodage d'un nouveau mot de code. Cela permet d'optimiser le temps de décodage et de limiter les accès concurrents à la mémoire partagée.

Selon un deuxième aspect, la présente invention concerne un dispositif de réception comportant un décodeur multicœur selon l'un quelconque des modes de réalisation décrits ci-avant.

Selon un troisième aspect, la présente invention concerne un satellite comportant un tel dispositif de réception.

**Présentation des figures**

L'invention sera mieux comprise à la lecture de la description suivante, donnée à titre d'exemple nullement limitatif, et faite en se référant aux figures 1 à 22 qui représentent :

[Fig. 1] une représentation schématique d'une matrice de parité d'un code LDPC,

[Fig. 2] une représentation schématique d'un graphe bipartite (graphe de Tanner) associé à une matrice de parité,

[Fig. 3] une illustration d'une méthode utilisée pour obtenir une matrice de parité d'un code LDPC quasi-cyclique,

[Fig. 4] une représentation schématique d'un exemple de mise en œuvre d'un procédé pour décoder un mot de code LDPC avec un ordonnancement par couches,

[Fig. 5] une représentation schématique d'un exemple de réalisation d'un décodeur LDPC selon l'invention,

[Fig. 6] une représentation schématique d'un exemple de réalisation d'un cœur du décodeur de la figure 5, pour mettre en œuvre un procédé de décodage tel que celui décrit à la figure 4,

[Fig. 7] un tableau présentant l'empreinte mémoire pour les messages de contrôle de parité (non compressés) pour différentes configurations candidates basées sur BG1,

[Fig. 8] une représentation graphique de l'empreinte mémoire pour les messages de contrôle de parité (non compressés) pour différentes configurations candidates basées sur BG1,

[Fig. 9] une représentation graphique de l'empreinte mémoire pour les messages de contrôle de parité (non compressés) pour différentes configurations candidates basées sur BG2,

[Fig. 10] un tableau présentant l'empreinte mémoire pour les variables d'estimation a priori pour différentes configurations candidates basées sur BG1,

[Fig. 11] une représentation graphique de l'empreinte mémoire pour les variables d'estimation a priori pour différentes configurations candidates basées sur BG1,

[Fig. 12] une représentation graphique de l'empreinte mémoire pour les variables d'estimation a priori pour différentes configurations candidates basées sur BG2,

[Fig. 13] un tableau listant un ensemble de configurations sélectionnées basées sur BG1,

[Fig. 14] un tableau listant un ensemble de configurations sélectionnées basées sur BG2,

[Fig. 15] une représentation graphique des configurations sélectionnées listées dans les tableaux des figures 13 et 14,

[Fig. 16] une représentation graphique des degrés des nœuds de contrôle de parité des matrices de base BG1 et BG2,

[Fig. 17] une représentation graphique des degrés des nœuds de contrôle de parité des matrices de base BG1 et BG2, après ordonnancement, pour le taux de codage minimal,

[Fig. 18] une représentation graphique des degrés des nœuds de contrôle de parité des matrices de base BG1 et BG2, après ordonnancement, pour un taux de codage 1/2,

[Fig. 19] une représentation graphique des degrés des nœuds de contrôle de parité des matrices de base BG1 et BG2, après ordonnancement, pour le taux de codage maximal,

[Fig. 20] une représentation schématique d'un autre exemple de réalisation d'un décodeur LDPC, avec une architecture multicœur comportant un groupe de quatre cœurs,

[Fig. 21] une représentation schématique d'un deuxième exemple de réalisation d'un décodeur LDPC multicœur comportant deux groupes de quatre cœurs,

[Fig. 22] une représentation schématique d'un troisième exemple de réalisation d'un décodeur LDPC multicœur avec une hiérarchie à deux niveaux.

Dans ces figures, des références identiques d'une figure à une autre désignent des éléments identiques ou analogues. Pour des raisons de clarté, les éléments représentés ne sont pas nécessairement à une même échelle, sauf mention contraire.

## Description détaillée de l'invention

Dans la suite de la description, on se place de manière non limitative dans le cas d'un décodeur LDPC pour des communications spatiales. Le décodeur peut notamment faire partie d'un dispositif récepteur embarqué dans un satellite destiné à être placé en orbite autour de la Terre.

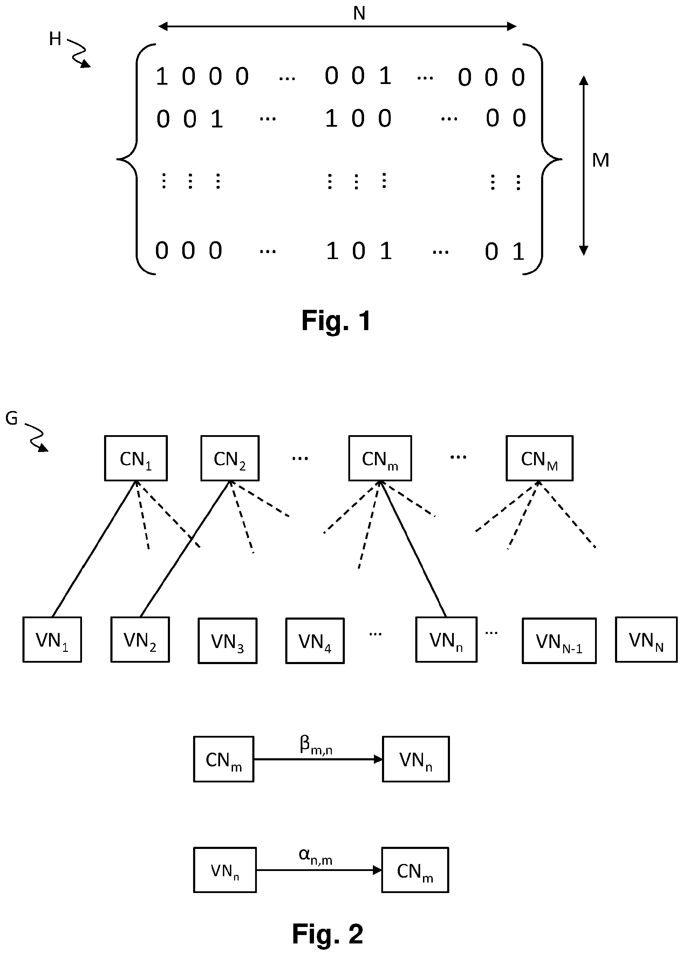

Un code LDPC est défini par une matrice de parité. La figure 1 représente schématiquement une matrice de parité H d'un code LDPC. On se place dans le cas d'un code LDPC binaire. La matrice de parité H est donc une matrice binaire, ce qui signifie que chaque élément de la matrice H est soit un '0' soit un '1'. On considère que la matrice H est de taille M x N, avec M et N des entiers positifs. La matrice comporte donc M lignes et N colonnes. La matrice de parité H est de faible densité, c'est-à-dire que le nombre d'éléments de la matrice égaux à '1' est relativement faible par rapport au nombre total M x N d'éléments de la matrice. Par exemple, le nombre d'éléments non nuls de la matrice est inférieur à 1% du nombre total d'éléments de la matrice.

Tel qu'illustré sur la figure 2, un code LDPC peut également être représenté sous la forme d'un graphe G bipartite (graphe de Tanner) présentant des connexions entre N nœuds de variable $VN_n$ (n variant entre 1 et N) et M nœuds de contrôle de parité $CN_m$ (m variant entre 1 et M). Chaque élément non nul de la matrice de parité H correspond à une connexion entre un nœud de variable $VN_n$ et un nœud de contrôle de parité $CN_m$. Chaque ligne de la matrice de parité H correspond à une équation de parité associée à un nœud de contrôle de parité $CN_m$. Chaque colonne de la matrice de parité H correspond à une variable associée à un nœud de variable $VN_n$. Un mot de code à décoder correspond à un ensemble de valeurs prises respectivement par les variables associées aux N nœuds de variable (c'est l'ensemble des valeurs estimées des bits du mot de code).

Un mot de code peut présenter une taille relativement importante, par exemple une taille supérieure ou égale à mille bits (N ≥ 1000), voire supérieure à dix-mille bits (N ≥ 10000). On se place dans le cas d'un décodeur LDPC qui supporte différentes tailles de mot de code, et différents taux de codage. Le taux de codage correspond au rapport entre le nombre de bits utiles dans un mot de code sur le nombre total de bits d'un mot de code. Plus le taux de codage est proche de '1', plus la complexité calculatoire est faible et plus le débit utile peut être élevé ; en contrepartie, le pouvoir de correction d'erreurs est plus faible. Inversement, plus le taux de codage est proche de '0' et plus le pouvoir de correction d'erreurs est important ; en contrepartie, la complexité calculatoire est plus forte et le débit utile est moins élevé. Le nombre de lignes M et la densité de la matrice de parité dépendent généralement du taux de codage.

Le décodage d'un mot de code LDPC est basé sur un échange itératif d'informations sur la vraisemblance des valeurs prises par les bits du mot de code.

Le processus itératif de décodage est basé sur un algorithme de propagation de croyance qui repose sur un échange de messages entre les nœuds de variable $VN_n$ et les nœuds de contrôle de parité $CN_m$.

Tel qu'illustré sur la figure 2, un message envoyé par un nœud de contrôle de parité $CN_m$ à destination d'un nœud de variable $VN_n$ est noté $\beta_{m,n}$. La valeur d'un message $\beta_{m,n}$ est calculée au niveau du nœud de parité $CN_m$ pour chacun des nœuds de variable $VN_n$ connectés au nœud de contrôle de parité $CN_m$ sur le graphe G.

Un message envoyé par un nœud de variable $VN_n$ à destination d'un nœud de contrôle de parité $CN_m$ est noté $\alpha_{n,m}$. La valeur d'un message $\alpha_{n,m}$ est calculée au niveau d'un nœud de variable $VN_n$ pour chacun des nœuds de parité $CN_m$ connectés au nœud de variable $VN_n$ sur le graphe G.

C'est un processus itératif : les messages $\alpha_{n,m}$ sont calculés à partir des messages $\beta_{m,n}$ précédemment calculés, et les messages $\beta_{m,n}$ sont calculés à partir des messages $\alpha_{n,m}$ précédemment calculés. Ce processus itératif prend en entrée des variables d'estimation a priori du mot de code qui correspondent par exemple à des logarithmes de rapport de vraisemblance (LLR pour « Log-Likelihood Ratio » en anglais). Ce sont des valeurs représentatives de la probabilité que la valeur d'un bit du mot de code soit égale à '1' ou à '0' (logarithme du rapport entre la probabilité que la valeur du bit est égale à '0' et la probabilité que la valeur du bit est égale à '1').

Des variables d'estimation a posteriori $\gamma_n$ (n variant de 1 à N) des bits du mot de code sont également calculées itérativement à partir des messages $\beta_{m,n}$. Ces valeurs $\gamma_n$ sont également représentatives de la probabilité que la valeur d'un bit du mot de code soit égale à '1' ou à '0'. Elles permettent de prendre une décision sur la valeur de chacun des bits du mot de code. Un syndrome peut alors être calculé à partir des valeurs estimées des bits du mot de code et des équations de parité définie par la matrice de parité H. Si on note c = ($c_1$, $c_2$, ..., $c_N$) l'ensemble des valeurs estimées des bits du mot de code, alors le syndrome s est défini par l'équation matricielle s = H * $c^T$. Un syndrome nul signifie que les valeurs estimées des bits du mot de code satisfont les équations de parité.

Différents algorithmes conventionnels peuvent être envisagés pour le processus itératif de décodage LDPC (BP-SPA, Min-Sum, Offset Min-Sum). Ces algorithmes sont connus de l'homme du métier. Les sections 2.3.1 et 2.3.3 du document « *Efficient Hardware Implementations of LDPC Decoders through Exploiting Impreciseness in Message-Passing Decoding Algorithms* », T.T Nguyen Ly (document référencé par la suite par « Ref1 »), décrivent respectivement un exemple de processus itératif de décodage LDPC avec l'algorithme BP-SPA et avec l'algorithme Min-Sum dans le cas d'un ordonnancement par inondation.

Pour réduire la complexité d'implémentation matérielle du décodeur LDPC, il est possible d'utiliser des structures particulières de la matrice de parité H qui confèrent à la matrice une organisation en couches horizontales ou verticales. Par exemple, une couche horizontale de la matrice de parité H peut être définie comme un ensemble de lignes consécutives définies de telle sorte que, pour une variable donnée (c'est-à-dire pour une colonne donnée de la matrice de parité H), la couche ne présente qu'un seul élément non nul.

Cette structure en couche permet de paralléliser les calculs des messages de contrôle de parité au sein d'une couche car les équations de parité d'une couche ne font pas intervenir plus d'une fois une variable du mot de code. En effet, si une couche ne présente qu'un seul élément non nul pour une variable donnée, cela signifie que les nœuds de variable $VN_n$ connectés à un nœud de contrôle de parité $CN_m$ d'une couche ne sont pas connectés à un autre nœud de contrôle de parité de ladite couche.

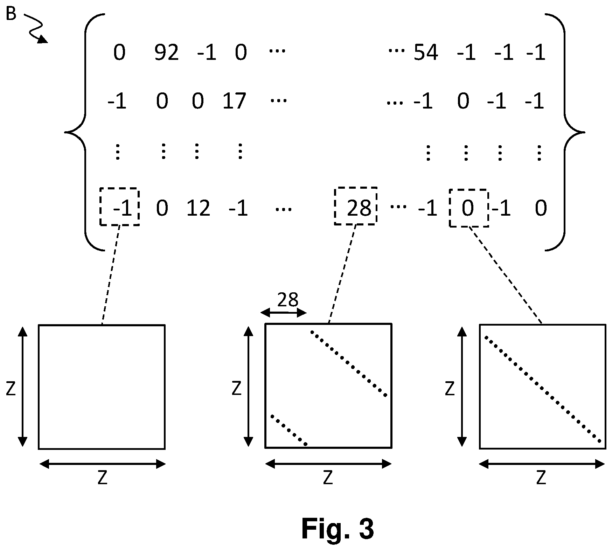

Il existe différentes façons d'obtenir une matrice de parité H présentant une structure en couches. Notamment, et tel qu'illustré sur la figure 3, il est possible d'obtenir une matrice de parité H à partir d'une matrice de base B de taille R x C en remplaçant chaque élément de la matrice de base B par une matrice de taille Z x Z correspondant soit à une matrice nulle, soit à la matrice identité, soit à un décalage de la matrice identité. La matrice de parité comporte alors R x Z lignes (M = R x Z) et C x Z colonnes (N = C x Z). Le terme Z est un généralement appelé « facteur d'expansion ». Les sous-matrices de taille Z x Z sont généralement appelées « matrices circulantes ». Les termes R, C et Z sont des entiers positifs. Un code LDPC défini par une telle matrice de parité H est appelé code LDPC « quasi-cyclique » (QC-LDPC).

Par exemple, et tel qu'illustré sur la figure 3, chaque élément de la matrice de base B est un entier ayant pour valeur '-1', '0', ou une valeur inférieure à Z. Un élément de la matrice de base B ayant pour valeur '-1' est remplacé par la matrice nulle ; un élément de la matrice de base B ayant pour valeur '0' est remplacé par la matrice identité ; un élément de la matrice de base B ayant une valeur d comprise entre 1 et (Z-1) est remplacé un décalage de valeur d de la matrice identité.

Une couche horizontale de la matrice de parité H peut alors être définie comme un ensemble de $Z_P$ lignes consécutives de la matrice de parité H provenant d'une ligne de la matrice de base B, avec $Z_P \leq Z$.

Dans une architecture par couches horizontales, les calculs sont principalement centrés sur les nœuds de contrôle de parité $CN_m$. Le nombre $Z_P$ correspond au nombre d'unité fonctionnelles utilisées pour exécuter en parallèle les calculs effectués au niveau des nœuds de contrôle de parité. Lorsque $Z_P = Z$, le niveau de parallélisation est maximal.

La section 2.5.2 du document Ref1 décrit un exemple de processus itératif de décodage LDPC avec l'algorithme Min-Sum dans le cas d'un ordonnancement par couches horizontales. Les variables d'estimation a posteriori $\gamma_n$ sont initialisées avec les variables d'estimation a priori (LLRs). Les messages $\beta_{m,n}$ sont initialisés à zéro. Ensuite, à chaque itération, les différentes couches sont traitées successivement. Pour chaque couche : les messages $\alpha_{n,m}$ sont calculés à partir des messages $\beta_{m,n}$ et des variables d'estimation a posteriori $\gamma_n$ ; les messages $\beta_{m,n}$ sont calculés à partir des messages $\alpha_{n,m}$ ; les variables d'estimation a posteriori $\gamma_n$ sont calculées à partir des messages $\beta_{m,n}$ ; un syndrome partiel peut alors être calculé à partir des variables d'estimation a posteriori $\gamma_n$.

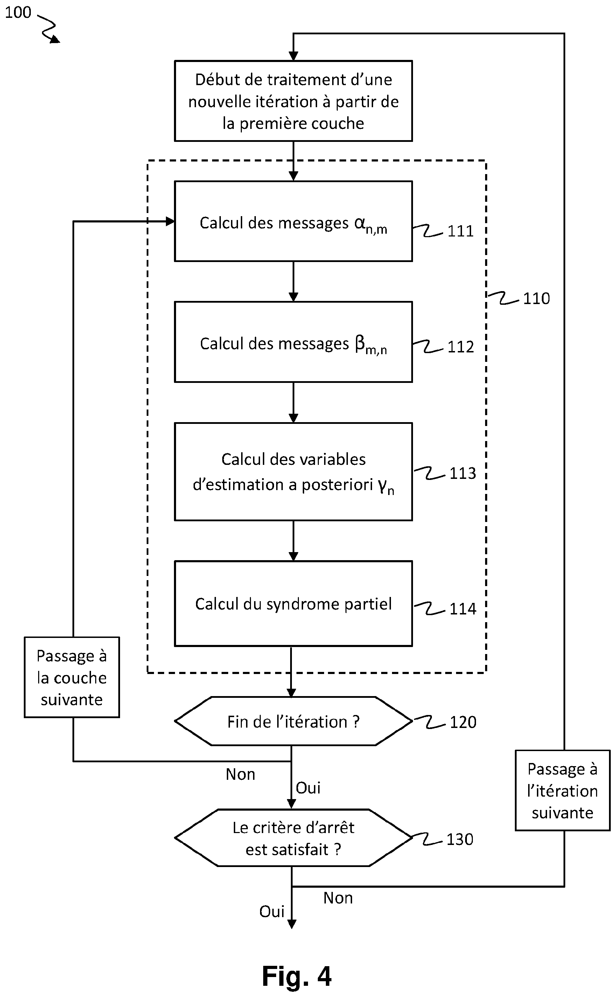

La figure 4 illustre schématiquement un exemple de mise en œuvre d'un procédé 100 pour décoder un mot de code LDPC avec une architecture en couches horizontales.

Tel qu'illustré sur la figure 4, le procédé 100 comprend l'exécution d'une ou plusieurs itérations jusqu'à ce qu'un critère d'arrêt soit satisfait. Chaque itération comprend le traitement successif des couches de la matrice de parité H. Le traitement 110 d'une couche comprend :

- un calcul 111 de messages de variable $\alpha_{n,m}$, pour les nœuds de variables $VN_n$ impliqués dans ladite couche,
- un calcul 112 de messages de contrôle de parité $\beta_{m,n}$, pour les nœuds de contrôle de parité $CN_m$ impliqués dans ladite couche,
- un calcul 113 des variables d'estimation a posteriori $\gamma_n$,
- un calcul 114 d'un syndrome partiel pour ladite couche.

Le calcul 111 d'un message de variable $\alpha_{n,m}$ est effectué pour chaque nœud de variable $VN_n$ impliqué dans la couche en cours de traitement et pour chacun des nœuds de contrôle de parité $CN_m$ connectés audit nœud de variable $VN_n$. Les messages $\alpha_{n,m}$ sont calculés à partir des valeurs courantes des variables d'estimation a posteriori $\gamma_n$ et à partir des valeurs courantes des messages de contrôle de parité $\beta_{m,n}$. Ces valeurs courantes correspondent soit aux valeurs d'initialisation (pour la première itération) soit aux valeurs calculées lors de l'itération précédente. Par exemple, un message $\alpha_{n,m}$ est calculé tel que $\alpha_{n,m} = \gamma_n - \beta_{m,n}$.

Le calcul 112 d'un message de contrôle de parité $\beta_{m,n}$ est effectué pour chaque nœud de contrôle de parité $CN_m$ impliqué dans la couche en cours de traitement et pour chacun des nœuds de variable $VN_n$ connectés audit nœud de contrôle de parité $CN_m$. Les messages $\beta_{m,n}$ sont calculés à partir des valeurs courantes des messages de variable $\alpha_{n,m}$. Par exemple, un message $\beta_{m,n}$ est calculé en considérant l'ensemble des messages $\alpha_{n',m}$ associés au nœud de contrôle de parité $CN_m$ en excluant le message $\alpha_{n,m}$ associé au nœud de variable $VN_n$ ; la valeur absolue d'un message $\beta_{m,n}$ est égale à la plus petite valeur absolue des messages $\alpha_{n',m}$ considérés ; le signe d'un message $\beta_{m,n}$ est égal au produit des signes des messages $\alpha_{n',m}$ considérés.

Le calcul 113 d'une valeur de la variable d'estimation a posteriori $\gamma_n$ est effectué pour chaque bit du mot de code. Par exemple, les $\gamma_n$ sont calculés à partir des valeurs courantes des messages de contrôle de parité $\beta_{m,n}$ et des valeurs courantes des messages de variable $\alpha_{n,m}$ de telle sorte que $\gamma_n = \alpha_{n,m} + \beta_{m,n}$.

Le calcul 114 d'un syndrome partiel pour la couche en cours de traitement est effectué en appliquant les équations de parité de ladite couche aux variables d'estimation a posteriori $\gamma_n$. Le syndrome partiel est alors un vecteur de taille L.

Le procédé 100 comporte, à la fin du traitement de chaque couche, une vérification 120 si l'itération est terminée ou non. L'itération est terminée lorsque toutes les couches ont été traitées.

A la fin d'une itération, le procédé 100 comporte une évaluation 130 d'un critère d'arrêt. Il est par exemple envisageable de considérer que le critère d'arrêt est satisfait lorsque tous les syndromes partiels calculés respectivement pour les différentes couches sont nuls. D'autre critères d'arrêt peuvent toutefois être envisagés : il est par exemple aussi possible de considérer que le critère d'arrêt est satisfait lorsque les syndromes partiels des différentes couches sont tous nuls pour un nombre prédéterminé d'itérations successives. Selon encore un autre exemple, le critère d'arrêt est satisfait si, pour une pluralité d'itérations successives, le nombre d'itérations pour lesquelles tous les syndromes partiels sont nuls auquel est retranché le nombre d'itérations pour lesquelles l'un au moins des syndromes partiels est non nul est supérieur ou égal à un seuil d'arrêt prédéterminé.

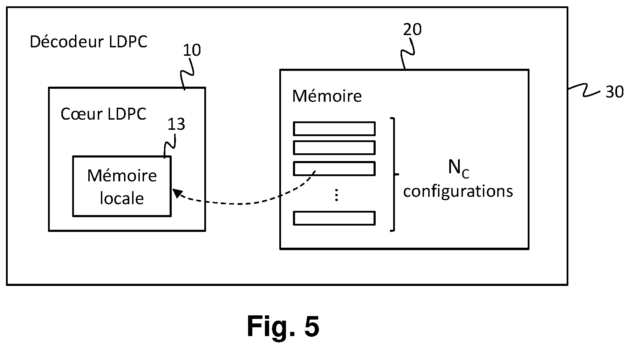

La figure 5 représente schématiquement un exemple de réalisation d'un décodeur 30 LDPC comportant au moins un cœur 10 et une mémoire 20 non volatile dans laquelle est mémorisé un nombre $N_C$ de configurations prédéfinies. Le cœur 10 est une unité de calcul (un processeur) adaptée pour être dynamiquement configuré avec l'une quelconque des $N_C$ configurations prédéfinies mémorisées dans la mémoire 20 afin de décoder un mot de code LDPC en utilisant cette configuration. Tel qu'illustré sur la figure 5, le cœur 10 comporte une mémoire 13 locale de configuration dont la taille est au moins égale à la plus grande des tailles des $N_C$ configurations prédéfinies mémorisées dans la mémoire 20. Ainsi, chacune des $N_C$ configurations peut être temporairement chargée dans la mémoire 13 locale pour le décodage d'un mot de code LDPC. Une nouvelle configuration est chargée dans la mémoire 13 locale à chaque fois qu'un nouveau mot de code LDPC doit être décodé avec une configuration différente de celle qui est présentement chargée dans la mémoire 13 locale. Le cœur 10 est adapté pour mener le procédé 100 de décodage LDPC itératif décrit ci-avant en référence à la figure 4. Le cœur 10 est par exemple implémenté sous la forme d'un circuit intégré spécifique de type ASIC (acronyme anglais pour « Application-Specific Integrated Circuit »), ou un circuit intégré reprogrammable de type FPGA (acronyme anglais pour « Field-Programmable Gate Array »).

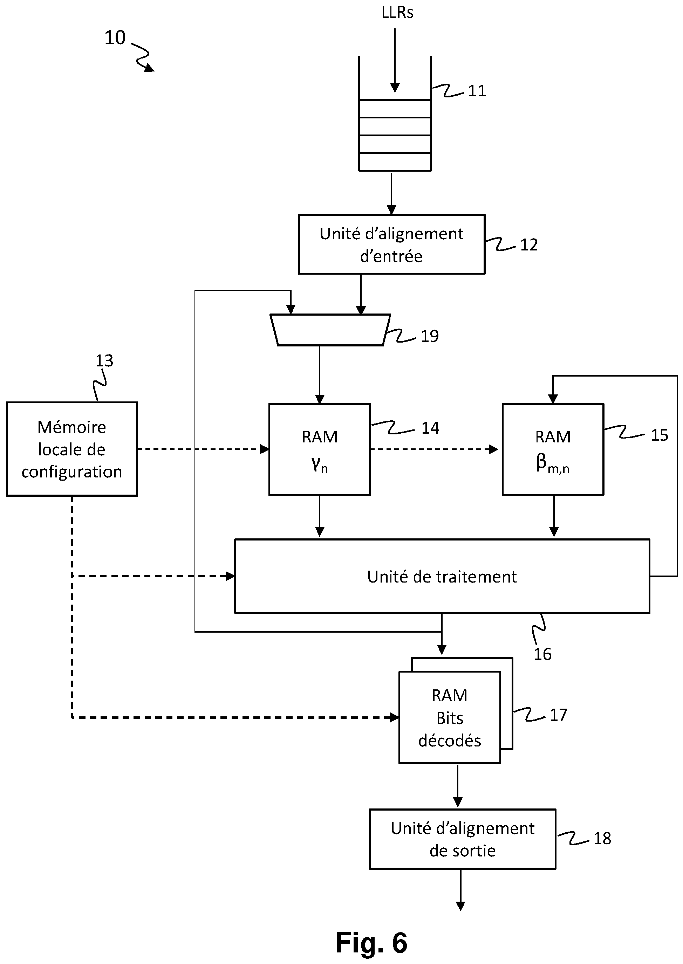

La figure 6 illustre schématiquement un exemple de réalisation du cœur 10 décrit ci-avant en référence à la figure 5. Il convient toutefois de noter qu'il existe dans la littérature de nombreuses architectures possibles pour l'implémentation d'un cœur LDPC. Dans l'exemple illustré à la figure 5, le cœur 10 comporte :

- une mémoire tampon d'entrée 11 de type premier entré-premier sorti (« First In First Out » ou FIFO dans la littérature anglo-saxonne) pour mettre en mémoire une trame de données pendant qu'une autre trame de données est en cours de traitement,
- une unité d'alignement d'entrée 12 pour former des blocs de bits de données à décoder de la taille du facteur de parallélisation $Z_P$,
- une mémoire 13 locale de configuration, par exemple une mémoire volatile de type RAM (« Random Access Memory »), dans laquelle sont mémorisées des informations de configuration relative au code LDPC, notamment la matrice de parité H à utiliser (qui peut être mémorisée sous toute forme adaptée),
- une mémoire 14 volatile dans laquelle sont mémorisés les valeurs courantes des variables d'estimation a posteriori $\gamma_n$,
- une mémoire 15 volatile dans laquelle sont mémorisés les valeurs courantes des messages de contrôle de parité $\beta_{m,n}$,
- une unité de traitement 16 configurée pour exécuter les itérations du processus de décodage, c'est-à-dire notamment pour mettre en œuvre le réseau de permutation (opérations de décalage de la matrice identité), pour effectuer les calculs des variables d'estimation a posteriori $\gamma_n$, des messages $\alpha_{n,m}$ et $\beta_{m,n}$, des syndromes partiels, et pour déterminer si le critère d'arrêt est satisfait,
- un multiplexeur 19 pour aiguiller dans la mémoire 14 les valeurs des variables d'estimation a priori (pour la première itération) ou les valeurs des variables d'estimation a posteriori $\gamma_n$ calculées par l'unité de traitement 16 (pour les itérations suivantes),
- une mémoire 17 volatile dans laquelle sont mémorisées les valeurs de décision dure (« hard decision » dans la littérature anglo-saxonne) des bits du mot de code,
- une unité d'alignement de sortie 18 pour adapter la taille des blocs de bits de données décodés à la taille attendue en sortie du décodeur 10.

Compatibilité avec la 5G :

Le standard 3GPP (acronyme anglais de « 3rd Generation Partnership Project », une coopération entre organismes de normalisation en télécommunications), et plus particulièrement le document de spécification technique 3GPP TS 38.212 (version 15.0.0 et ultérieures) décrit les configurations LDPC qui doivent être supportées par un dispositif compatible avec le standard 5G (cinquième génération du standard de communications mobiles 3GPP).

Chaque configuration LDPC 5G correspond à un triplet de paramètres {K, R, Z} et à une matrice de parité. Le paramètre K correspond à la taille du mot encodé (c'est la taille des données utiles dans le mot de code LDPC). Le paramètre Z correspond à un facteur d'expansion (« lifting size Z »). Le paramètre R correspond au taux de codage. Cela correspond sensiblement au rapport entre la taille du mot encodé et la taille du mot de code LDPC (rapport K/N). De façon plus exacte, le taux de codage R correspond au rapport K/(N-$N_P$), où $N_P$ est un nombre de bits poinçonnés.

Les codes LDPC 5G sont basés sur des matrices de parité quasi-cycliques pouvant être construites à partir d'une matrice de base BG1 ou BG2 (« Base Graph 1 ou Base Graph 2 »).

La matrice de base BG1 comporte au maximum 46 lignes et 68 colonnes. La matrice de base BG2 comporte au maximum 42 lignes et 52 colonnes. Chaque entrée de la matrice de base peut être étendue avec le facteur d'expansion Z (« lifting size Z » dans le document 3GPP TS 38.212). Le nombre de lignes et de colonnes à utiliser dépend du taux de codage R (plus le taux de codage est faible et plus la taille de la matrice de base est grande).

Le choix de la matrice de base BG1 ou de la matrice de base BG2 est défini par la spécification en fonction des valeurs de K et R (voir section 6.2.2 du document 3GPP TS 38.212) :

- si K ≤ 3824 et R ≤ 0.67, alors BG2 est sélectionnée,
- si K ≤ 292, alors BG2 est sélectionnée,
- si R ≤ 0.25, alors BG2 est sélectionnée,
- sinon, BG1 est sélectionnée.

Une fois la matrice de base sélectionnée, la spécification définit un paramètre $K_b$ qui représente le nombre de colonnes de la matrice de base à utiliser pour traiter les bits d'information du mot de taille K :

- pour BG1, $K_b$ = 22 ;
- pour BG2 :

  ○ si K > 640, alors $K_b$ = 10,
  ○ si 560 < K ≤ 640, alors $K_b$ = 9,
  ○ si 192 < K ≤ 560, alors $K_b$ = 8,
  ○ si K ≤ 192, alors $K_b$ = 6.

Le facteur d'expansion Z est déterminé comme étant la plus petite valeur de Z satisfaisant $K_b$ x Z ≥ K.

Connaissant le facteur d'expansion Z, on peut définir à partir de la table 5.3.2-1 de la spécification 3GPP TS 38.212 à quel indice $i_{LS}$ il correspond. La table 5.3.2-2 permet ensuite de construire la matrice de base en la remplissant avec des valeurs comprises entre 0 et (Z-1). Comme décrit précédemment en référence à la figure 3, un élément de la matrice de base ayant pour valeur '-1' est remplacé par la matrice nulle ; un élément de la matrice de base ayant pour valeur '0' est remplacé par la matrice identité ; un élément de la matrice de base ayant une valeur entière 'd' comprise entre 1 et (Z-1) est remplacé un décalage de valeur 'd' de la matrice identité.

Un très grand nombre de configurations différentes sont supportées par la spécification. Par exemple, K peut varier de quelques bits ou quelques dizaines de bits à plusieurs milliers de bits (jusqu'à 8448 bits) ; la spécification supporte plus de cinquante valeurs possibles pour Z (valeurs comprises entre 2 et 384) ; un grand nombre de valeurs différentes sont envisageables pour le taux de codage R (le taux de codage est en relation directe avec le nombre de lignes de la matrice de base).

La nécessité de supporter un très grand nombre de configurations différentes pour les codes LDPC 5G s'explique notamment par le besoin d'avoir des codes compatibles en termes de taux de codage pour supporter l'IR-HARQ. L'IR-HARQ est utilisée notamment pour introduire de la diversité fréquentielle afin de minimiser les impacts du multi-trajet qui est très souvent présent dans les communications terrestres. L'IR-HARQ est également utilisée pour optimiser l'efficacité spectrale pour des communications caractérisées par un temps de propagation très faible.

Les codes LDPC de la 5G sont donc conçus pour être très flexibles et adaptables à un très large éventail de conditions de transmission. Cela signifie qu'ils utilisent des matrices de parité de longueur très variable, qui nécessitent une quantité importante de logique pour être implémentés en matériel. Aussi, le nombre de configurations différentes à supporter est tellement grand (plusieurs milliers de configurations différentes en 5G) qu'il n'est pas envisageable de précalculer les matrices de parité associées à ces configurations afin de les stocker en mémoire. Il est alors nécessaire de calculer dynamiquement la matrice de parité de la configuration retenue.

En contrepartie de cette ultra-flexibilité, les décodeurs LDPC 5G conventionnels sont généralement relativement peu efficaces en termes de matériel pour un traitement de bande spectrale fixe. En particulier, la grande flexibilité sur le facteur d'expansion Z entraine une complexité du réseau de permutation de l'architecture en couches. Cette complexité augmente l'empreinte des registres et des portes logiques du circuit. Cette complexité entraine également une augmentation du nombre d'étages du pipeline afin de maintenir une fréquence maximale élevée du circuit. Cette augmentation du nombre d'étages du pipeline réduit toutefois le débit global du décodeur en raison des aléas de données qui sont généralement résolus par des cycles d'attente (le terme « aléas de données », ou « data hazards » en anglais, est utilisé ici pour désigner une situation dans laquelle une instruction ne peut pas être exécutée car elle dépend de la valeur d'une autre instruction qui n'est pas encore disponible).

Avec un décodeur 5G conventionnel, il est possible d'atteindre des débits de données élevés avec des valeurs élevées pour le taux de codage R et pour le facteur d'expansion Z. Les décodeurs 5G conventionnels utilisent une architecture en couches avec plusieurs unités de traitement travaillant en parallèle, comme cela a été mentionné précédemment. Le facteur de parallélisation $Z_P$ est souvent choisi pour être le plus grand possible. Toutefois, pour des valeurs de facteur d'expansion plus petites, l'architecture parallèle devient souvent sous-optimale.

Pour les applications de communications satellitaires haut-débit (et éventuellement pour certaines autres applications spécifiques), l'ultra-flexibilité offerte par la 5G dans le choix des configurations LDPC n'est pas utile, et elle peut augmenter considérablement la complexité matérielle et la consommation d'énergie du dispositif embarqué à bord du satellite.

Dans le domaine des communications spatiales, où le canal de transmission est essentiellement de type AWGN (acronyme anglais de « Additive White Gaussian Noise », en français « bruit additif blanc gaussien »), l'intérêt d'utiliser l'IR-HARQ est nettement réduit. L'utilité de considérer l'intégralité des codes LDPC 5G (pour conserver une compatibilité en termes de taux de codage) est alors réduite.

Pour obtenir un décodeur LDPC compatible 5G présentant des bonnes performances en termes d'efficacité matérielle, la présente invention propose de sélectionner un nombre restreint de configurations parmi le très grand nombre de configurations LDPC supportées par le standard 3GPP TS 38.212.

Il peut en effet être intéressant de concevoir un décodeur LDPC qui soit compatible avec la 5G, au sens où il supporte au moins certaines configurations LDPC 5G, sans nécessairement supporter toutes les configurations LDPC 5G. Dans un système de communications satellitaires, les ressources à utiliser pour établir une communication entre une station terrestre (par exemple un terminal mobile 5G) et un satellite sont allouées par une station passerelle au sol. Parmi ces ressources figure la configuration LDPC à utiliser pour coder (à l'émission) et décoder (à la réception) un mot de code inclus dans un message échangé entre la station terrestre et le satellite. La station passerelle peut notamment comporter un module de contrôle de ressources radio configuré pour allouer uniquement des configurations LDPC 5G comprises dans les $N_C$ configurations prédéfinies.

Dans la suite, on note $N_C$ le nombre restreint de configurations supporté par le décodeur 30. Ce nombre $N_C$ est avantageusement peu élevé, de telle sorte que les matrices de parité associées à ces configurations sont précalculées et mémorisées dans la mémoire 20. Il n'est alors plus nécessaire de construire entièrement la matrice de parité à chaque fois qu'un nouveau mot de code doit être décodé avec un nouveau code LDPC. Cela permet de limiter la complexité du décodeur : le décodeur n'a pas besoin d'implémenter la logique nécessaire pour la construction de la matrice de parité, et le réseau de permutation peut être simplifié et optimisé pour les $N_C$ configurations retenues.

Les $N_C$ configurations prédéfinies forment donc un sous-groupe strict des configurations LDPC 5G définies dans le standard 3GPP TS 38.212.

Dans des modes particuliers de réalisation, le nombre $N_C$ de configurations prédéfinies est compris entre 8 et 512, voire entre 8 et 256, voire même entre 8 et 128. Une telle valeur de $N_C$ offre un compromis intéressant entre un nombre assez important de configurations pour couvrir un nombre suffisant de scénarios en termes de SNR et de débit souhaité, et un nombre assez faible de configurations pour limiter les besoins en mémoire et la complexité d'implémentation.

Chaque configuration correspond à un triplet {K, R, Z}, et à une matrice de parité construite en fonction d'une partie au moins des paramètres K, R et Z. Comme expliqué précédemment, en définissant K et R, on peut en déduire la matrice de base à utiliser (BG1 ou BG2), puis la valeur de Z, puis la matrice de parité complète.

Selon un autre exemple, il est possible de commencer par définir un ensemble de quelques valeurs préférées pour le facteur d'expansion Z auxquelles se limiteront les $N_C$ configurations, puis en déduire différentes valeurs possibles de K pour supporter certains taux de codage R. Comme expliqué précédemment, une matrice de parité peut être construite pour chaque triplet {K, R, Z} retenu.

Avantageusement, l'ensemble des valeurs prises par le paramètre Z parmi les $N_C$ configurations prédéfinies comprend au moins deux valeurs différentes. Cela permet ainsi de gérer différentes tailles de message (différentes valeurs de K).

Dans des modes particuliers de réalisation, l'ensemble des valeurs prises par le paramètre Z parmi les $N_C$ configurations prédéfinies comprend $N_Z$ valeurs $Z_i$ différentes et ordonnées par ordre croissant avec l'indice i (i est un indice variant entre 0 et $(N_Z-1)$), $N_Z$ étant un entier compris entre 2 et 32, voire entre 4 et 16, les valeurs $Z_i$ étant avantageusement choisies de telle sorte que, pour i variant entre 1 et $(N_Z-1)$, le rapport $\frac{Z_i}{Z_0}$ est égal à une valeur entière. De façon avantageuse, on peut choisir $N_Z \geq 8$ pour avoir une bonne variété dans les configurations supportées.

Il est alors avantageux de choisir une valeur de $Z_0$ égale au facteur de parallélisation $Z_P$ du décodeur 30 ($Z_P = Z_0$). Pour rappel, le facteur de parallélisation $Z_P$ correspond au nombre maximal d'unités fonctionnelles du cœur 10 pouvant être utilisées en parallèle pour exécuter les calculs des nœuds de contrôle de parité. De telles dispositions permettent en effet d'optimiser l'utilisation des ressources matérielles du décodeur pour la parallélisation et, comme on le verra par la suite, d'offrir plus de flexibilité pour résoudre des situations d'aléas de données.

Il convient toutefois de noter que la valeur $Z_0$

n'est pas nécessairement la plus petite valeur parmi l'ensemble des valeurs prises par le paramètre Z parmi les $N_C$ configurations prédéfinies (rien n'empêcherait d'avoir une configuration avec une valeur de Z strictement inférieure à $Z_P$, par exemple si cette configuration permet de traiter de façon spécifique des cas relativement rares de transmission de messages de petites tailles).

Pour optimiser l'implémentation matérielle du décodeur, il est également avantageux de choisir une valeur de $Z_0$ égale à une puissance de deux (autrement dit, une valeur de $Z_0$ pouvant s'écrire sous la forme $2^n$, où n est un entier positif). Cela permet en effet de maximiser l'utilisation matérielle des multiplexeurs et du réseau de permutation.

A titre d'exemple nullement limitatif, on peut choisir $Z_0 = 32$, $N_Z = 12$, et $Z_i = (i + 1) \times Z_0$ pour i variant entre 0 et ($N_Z$-1).

Pour les valeurs $Z_i$ retenues, il est avantageux de sélectionner des configurations qui limitent la taille du bus d'adressage de la mémoire 15 volatile du cœur 10 dans laquelle sont mémorisées les valeurs courantes des messages de contrôle de parité $\beta_{m,n}$.

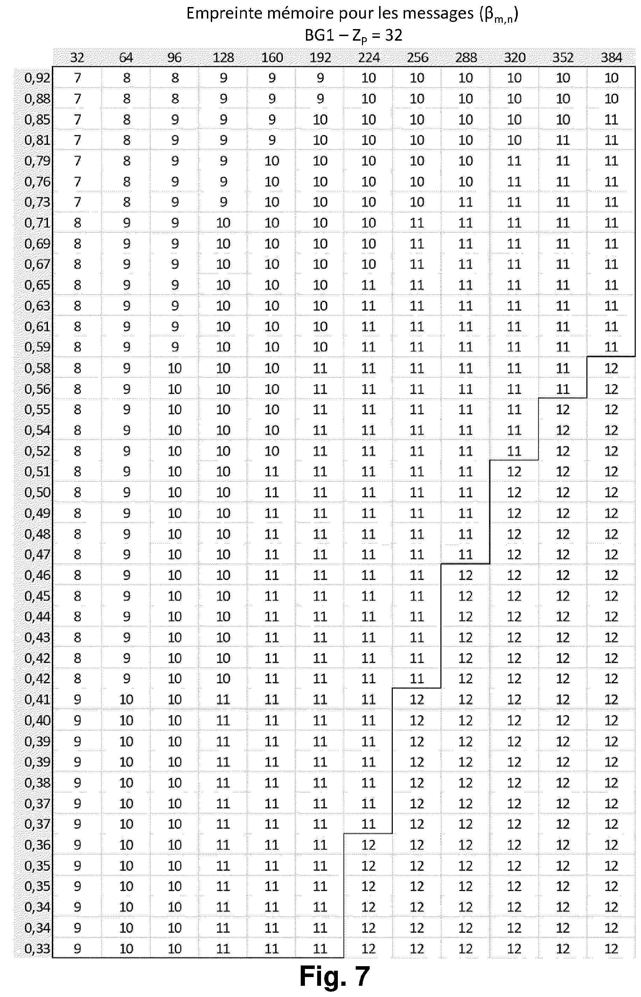

Le tableau en figure 7 donne la taille en bits du bus d'adressage de la mémoire 15 pour différentes configurations avec les valeurs $Z_i$ retenues lorsque la matrice de base à utiliser est BG1. Chaque colonne du tableau correspond à une valeur $Z_i$ particulière, chaque ligne du tableau correspond à une valeur de taux de codage R particulière. Pour un couple de valeur $\{Z_i ; R\}$, il est possible de déterminer la valeur correspondante du paramètre K. Chaque case du tableau de la figure 7 correspond donc à une configuration candidate.

La taille du bus d'adressage de la mémoire 15 pour les messages de contrôle de parité (non compressés) $\beta_{m,n}$ est égale à $\left\lceil log_2\left(\frac{N_{conn}}{Z_P}\right)\right\rceil$, où $N_{conn}$ correspond au nombre d'éléments non nuls (nombre de connexions) dans la matrice de parité de la configuration considérée. $N_{conn}$ correspond également à $Z_i$ multiplié par le nombre d'éléments non nuls dans les $m_B$ lignes et $n_B$ colonnes de la matrice de base utilisées pour la configuration considérée.

Tel qu'illustré sur la figure 7, il est par exemple avantageux de sélectionner les configurations supportées de telle sorte que la taille du bus d'adressage de la mémoire 15 pour les messages de contrôle de parité $\beta_{m,n}$ soit inférieure ou égale à $16 - \lfloor log_2(Z_P)\rfloor$ (c'est-à-dire inférieure ou égale à 11 lorsque $Z_P = 32$).

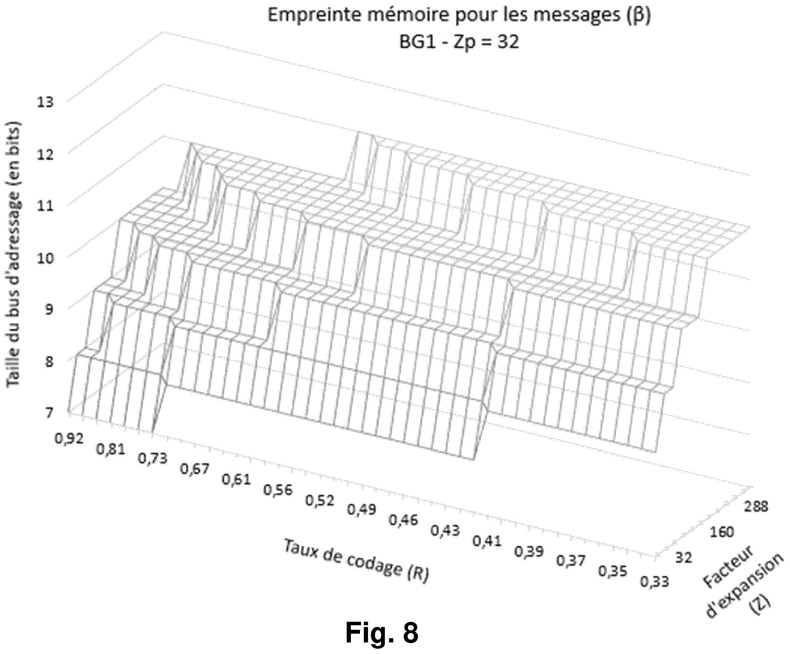

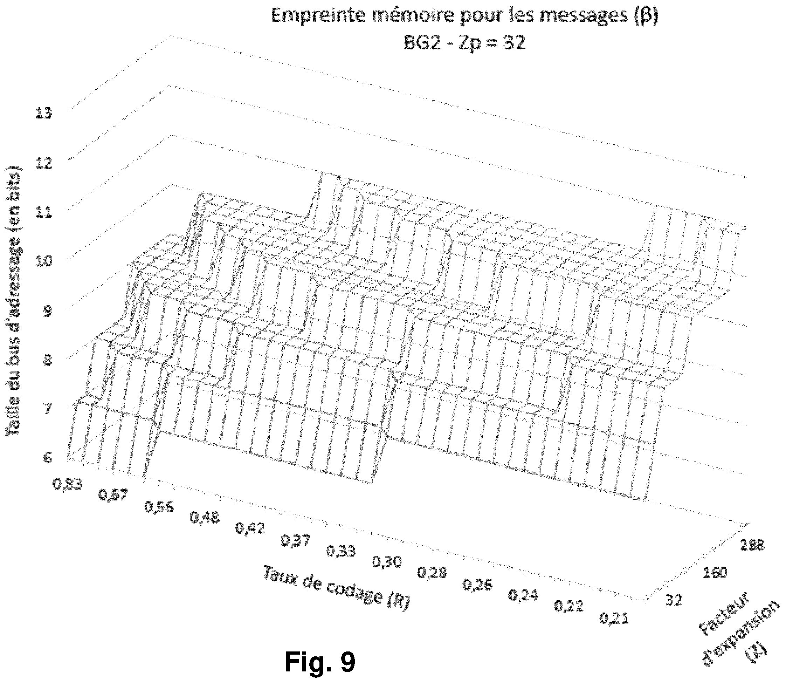

La figure 8 est une représentation graphique du tableau de la figure 7 (c'est une représentation graphique de la taille en bits du bus d'adressage de la mémoire 15 pour différentes configurations candidates avec les valeurs $Z_i$ retenues lorsque la matrice de base à utiliser est BG1). La figure 9 est une représentation graphique de la taille en bits du bus d'adressage de la mémoire 15 pour différentes configurations candidates avec les valeurs $Z_i$

retenues lorsque la matrice de base à utiliser est BG2. On peut observer que les configurations basées sur BG1 sont plus contraignantes que celles basées sur BG2.

Comme décrit à la section 4.3.1 du document Ref1, il est envisageable de « compresser » les messages de contrôle de parité $\beta_{m,n}$ traités par une unité fonctionnelle. Par exemple, plutôt que de mémoriser les valeurs des messages $\beta_{m,n}$ associés à un nœud de contrôle, il peut être suffisant de mémoriser les signes de ces messages, la valeur absolue d'au moins deux valeurs minimales parmi ces messages, et les index associés à ces valeurs minimales sauf une.

Ainsi, dans le cas non compressé, chaque entrée de la mémoire correspond à un message $\beta_{m,n}$, alors que dans le cas compressé, chaque entrée de la mémoire correspond aux données compressées (signes, min, index) d'une couche.

Dans le cas où les messages de contrôle de parité sont compressés, la taille du bus d'adressage de la mémoire 15 pour les messages de contrôle de parité est égale à $\left\lceil log_2\left(\frac{m_B \cdot Z_i}{Z_P}\right)\right\rceil$, où $m_B$ correspond au nombre de lignes de la matrice de base utilisées, et $\frac{m_B \cdot Z_i}{Z_P}$ correspond au nombre de couches dans la matrice de parité pour la configuration considérée ($m_B \cdot Z_i$ est égal au nombre M de lignes de la matrice de parité pour la configuration considérée).

Dans le cas où les messages de contrôle de parité sont compressés, il est par exemple avantageux de sélectionner les configurations supportées de telle sorte que la taille du bus d'adressage de la mémoire 15 pour les messages de contrôle de parité soit inférieure ou égale à $14 - \lfloor log_2(Z_P)\rfloor$ (c'est-à-dire inférieure ou égale à 9 lorsque $Z_P = 32$).

Pour les valeurs $Z_i$ retenues, il peut également être avantageux de sélectionner des configurations qui limitent la taille du bus d'adressage de la mémoire 14 volatile du cœur 10 dans laquelle sont mémorisées des valeurs courantes de variables d'estimation a posteriori $\gamma_n$ (le terme APP est également utilisé pour désigner les variables d'estimation a posteriori).

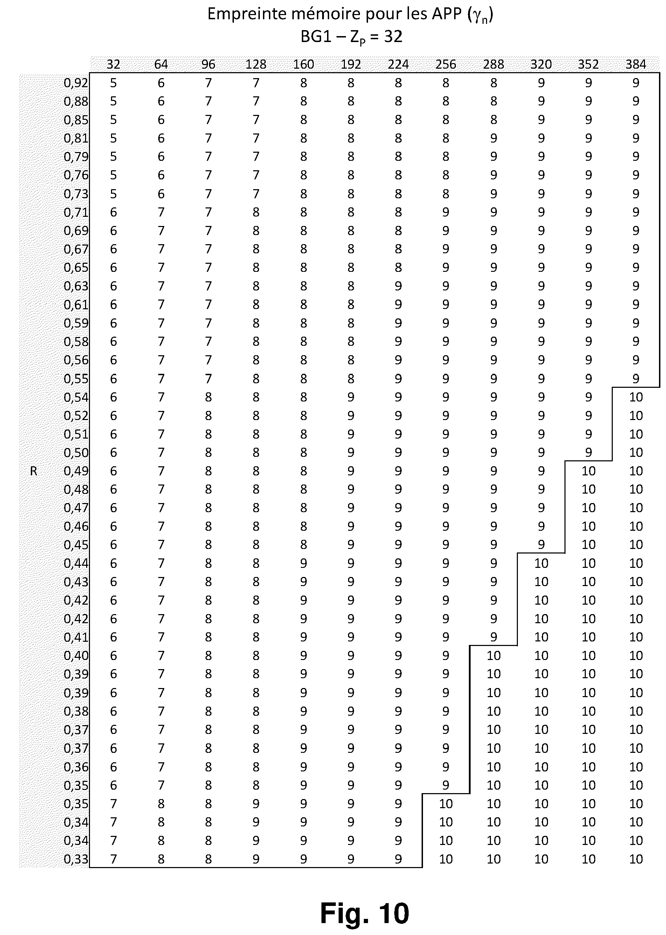

Le tableau en figure 10 donne la taille en bits du bus d'adressage de la mémoire 14 pour différentes configurations avec les valeurs $Z_i$ retenues lorsque la matrice de base à utiliser est BG1.

La taille du bus d'adressage de la mémoire 14 pour les variables d'estimation a posteriori $\gamma_n$ est égale à $\left\lceil log_2\left(\frac{N}{Z_P}\right)\right\rceil$, où N correspond à la taille d'un mot de code pour la configuration considérée. La taille N est égale à $n_B \cdot Z_i$, où $n_B$ correspond au nombre de colonnes de la matrice de base utilisées pour la configuration considérée.

Tel qu'illustré sur la figure 10, il est par exemple avantageux de sélectionner les configurations supportées de telle sorte que la taille du bus d'adressage de la mémoire 14 pour les variables d'estimation a posteriori $\gamma_n$

soit inférieure ou égale à $14 - \lfloor log_2(Z_P) \rfloor$ (c'est-à-dire inférieure ou égale à 9 lorsque $Z_P = 32$).

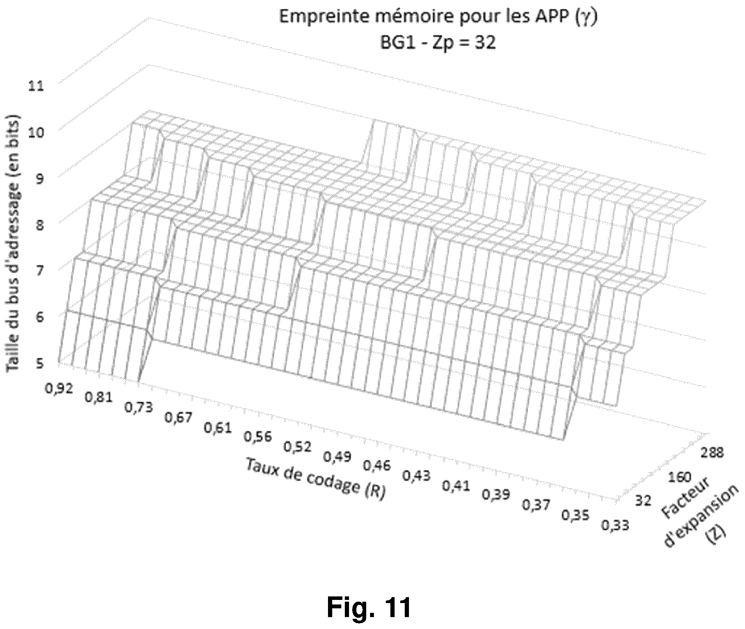

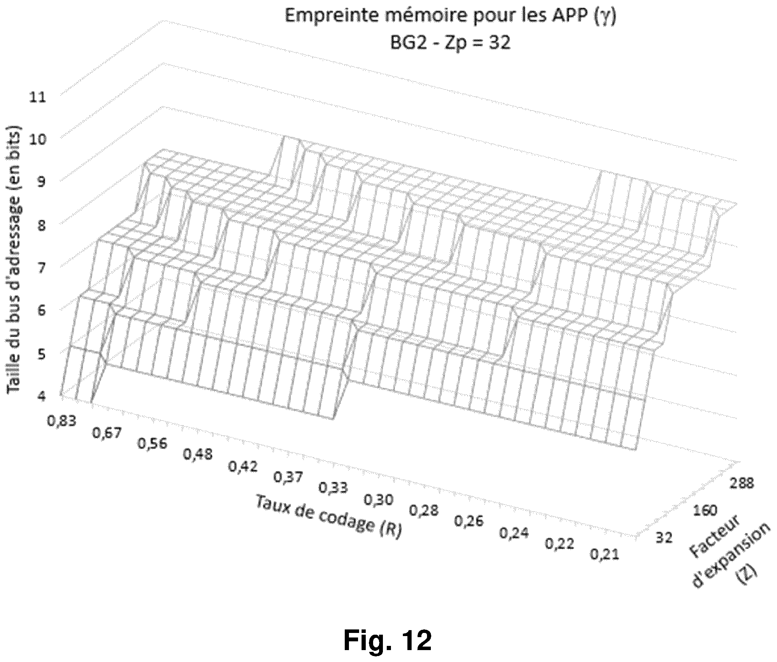

La figure 11 est une représentation graphique du tableau de la figure 10 (c'est une représentation graphique de la taille en bits du bus d'adressage de la mémoire 14 pour différentes configurations candidates avec les valeurs $Z_i$ retenues lorsque la matrice de base à utiliser est BG1). La figure 12 est une représentation graphique de la taille en bits du bus d'adressage de la mémoire 14 pour différentes configurations candidates avec les valeurs $Z_i$ retenues lorsque la matrice de base à utiliser est BG2. On peut observer que les configurations basées sur BG1 sont plus contraignantes que celles basées sur BG2.

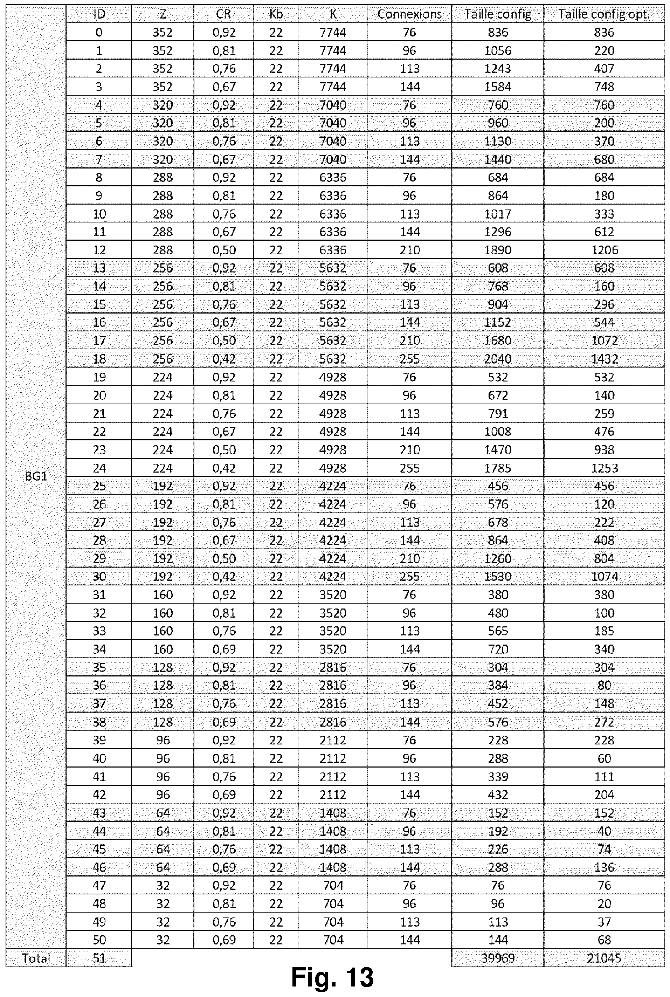

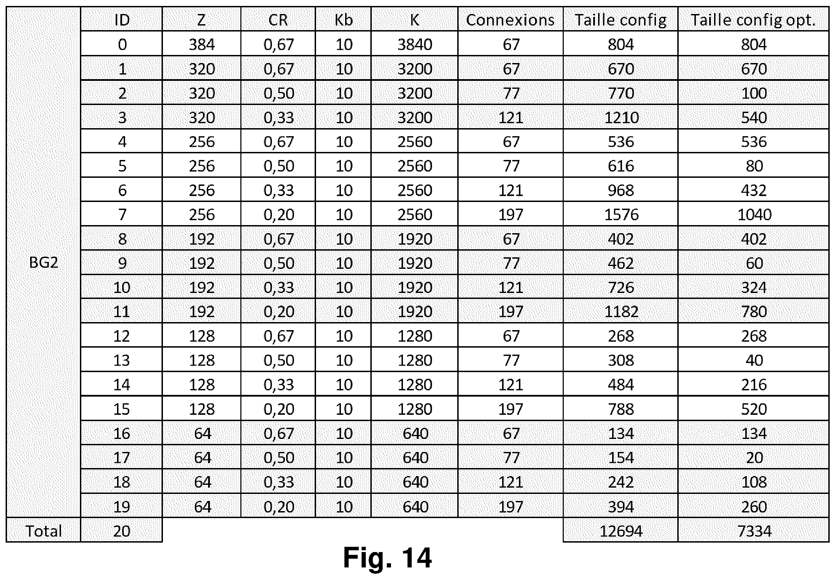

Dans l'exemple considéré, les configurations sélectionnées sont listées dans les tableaux en figure 13 et 14. Le tableau en figure 13 liste cinquante-et-une configurations sélectionnées basées sur BG1, tandis que le tableau en figure 14 liste vingt configurations sélectionnées basées sur BG2. Dans cet exemple, il y a donc un total de soixante-et-onze configurations ($N_C$ = 71) à mémoriser dans la mémoire 20 non volatile.

Dans les tableaux des figures 13 et 14, la colonne « Connexions » indique le nombre de connexions (nombre d'éléments non nuls) dans la matrice de base. Le nombre $N_{conn}$ de connexions dans la matrice de parité correspond au nombre de connexions dans la matrice de base multiplié par le facteur d'expansion Z.

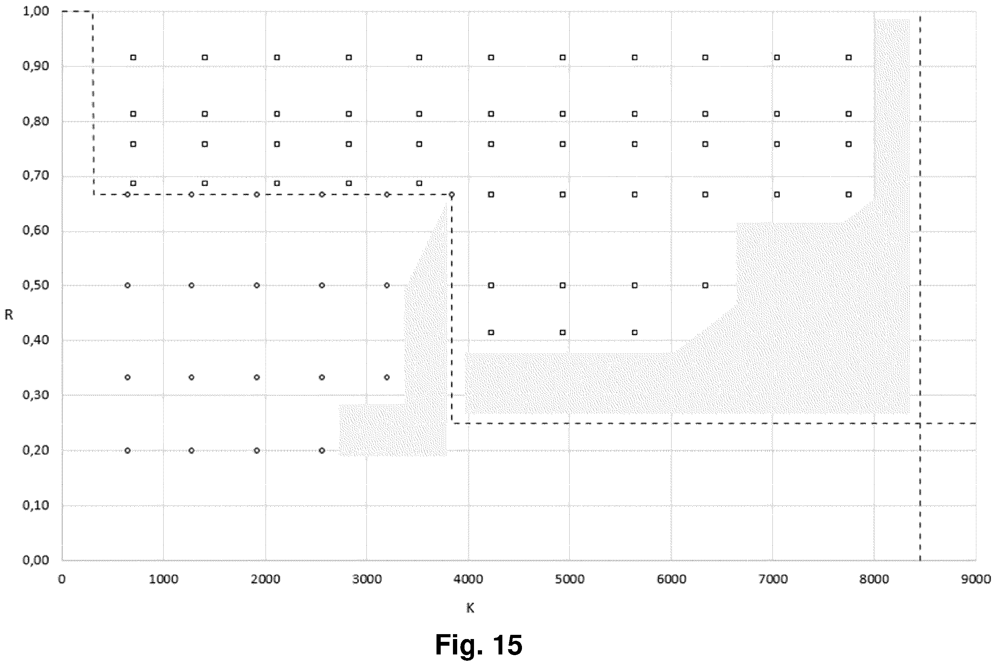

La figure 15 est une représentation graphique des configurations sélectionnées listées dans les tableaux des figures 13 et 14. Sur cette figure, les configurations sélectionnées basées sur BG1 sont représentées par des carrés, les configurations sélectionnées basées sur BG2 sont représentées par des ronds. Il apparaît clairement sur cette représentation que, de façon avantageuse, pour K > 3824, le nombre de configurations prédéfinies présentant un facteur d'expansion égal à $Z_i$ est une fonction décroissante avec la valeur de $Z_i$. De façon similaire, pour K ≤ 3824 et R ≤ 0,67, le nombre de configurations prédéfinies présentant un facteur d'expansion égal à $Z_i$ est une fonction décroissante avec la valeur de $Z_i$.

Les codes LDPC 5G présentent une distribution des degrés de parité des nœuds de contrôle $CN_m$ très irrégulière. Cela signifie que différents nœuds de contrôle peuvent avoir des nombres différents (et potentiellement très différents) de bits de données qui leur sont connectés. Le degré de parité d'un nœud de contrôle de parité $CN_m$ correspond au nombre de bits de données qui lui sont connectés ; cela correspond aussi au nombre d'équations de parité dans laquelle le nœud de contrôle est impliqué.

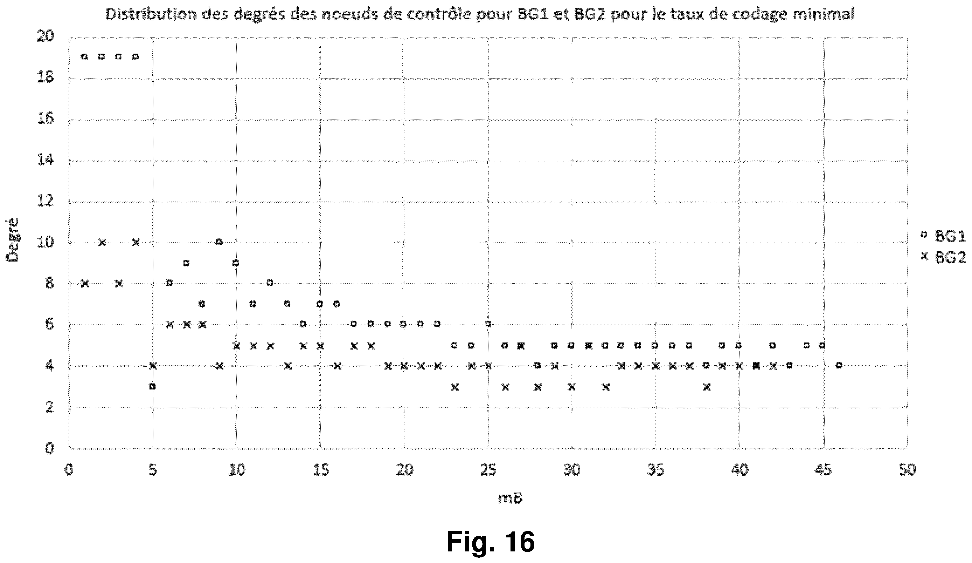

La figure 16 illustre cette irrégularité des codes LDPC 5G. La figure 16 représente les degrés des nœuds de contrôle de parité des matrices de base BG1 et BG2.

Sur la figure 16, les degrés des nœuds de contrôle de parité pour BG1 sont représentés par des carrés, les degrés des nœuds de contrôle de parité pour BG2 sont représentés par des croix.

Dans une architecture en couches, des nœuds de contrôle de parité $CN_m$ peuvent être exécutés en parallèle. Cependant, la distribution irrégulière des degrés de parité des nœuds de contrôle entraîne des situations où certains nœuds de contrôle ne peuvent pas être exécutés tant que les données en sortie des autres nœuds de contrôle ne sont pas disponibles. Il devient alors nécessaire d'insérer des cycles d'attente supplémentaires dans le processus de décodage. Cela réduit le débit global du décodeur.

Pour résoudre ce problème, il est possible d'ordonnancer d'une façon particulière et optimisée les nœuds de contrôle en fonction de leur degré de parité. En particulier, les nœuds de contrôle peuvent être ordonnancés par ordre croissant des degrés de parité (cela signifie que les nœuds de contrôle avec le moins de bits de données connectés sont exécutés en premier).

Il est également envisageable d'optimiser, à l'aide d'heuristiques, l'ordre des nœuds de contrôle présentant un même degré de parité, ou bien l'ordre des calculs au sein d'un nœud de contrôle.

Chaque configuration sélectionnée et mémorisée dans la mémoire 20 peut donc avantageusement comporter cet ordonnancement optimisé des nœuds de contrôle (c'est-à-dire une indication de l'ordre dans lequel les nœuds de contrôle doivent être exécutés). Cette approche ne peut pas être implémentée pour les décodeurs LDPC 5G conventionnels en raison du grand nombre de configurations différentes qu'ils doivent supporter. Cette approche s'applique toutefois très bien au décodeur 30 selon l'invention car le nombre $N_C$ de configurations prédéfinies est limité.

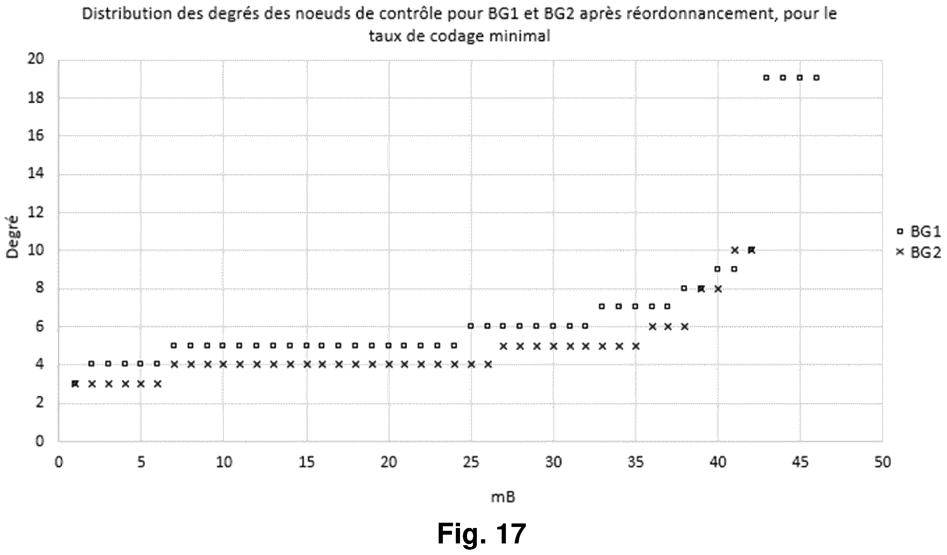

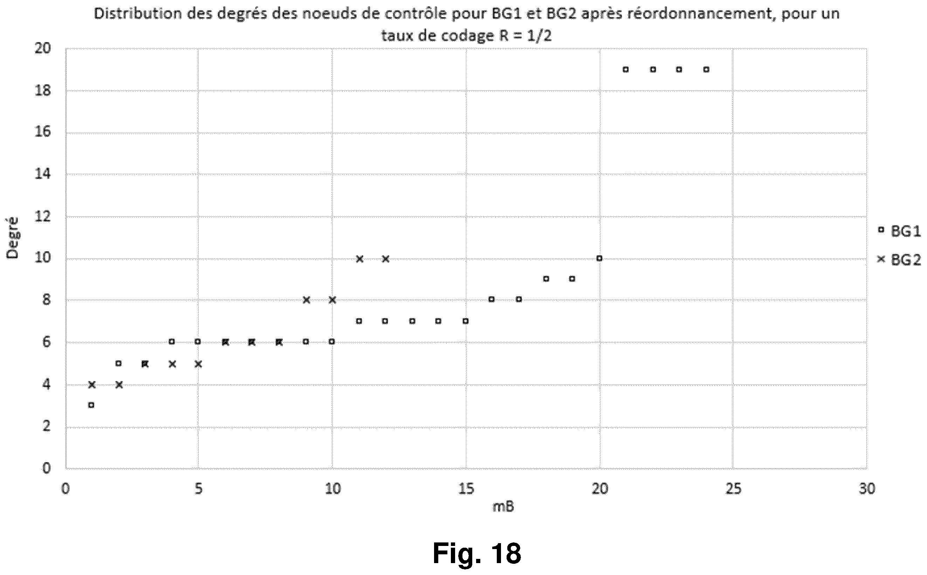

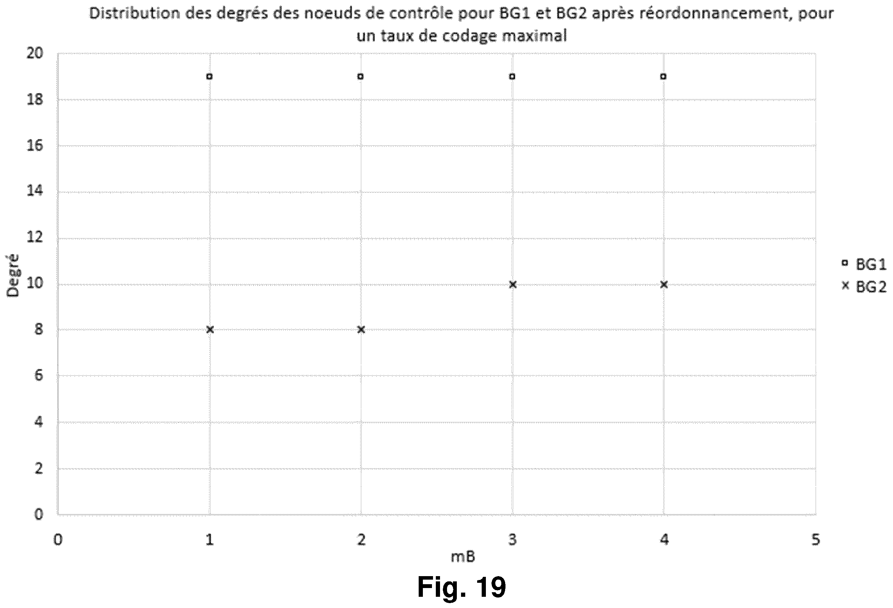

Les figures 17, 18 et 19 représentent respectivement les degrés des nœuds de contrôle de parité des matrices de base BG1 et BG2 après ordonnancement par ordre croissant des degrés de parité, pour différentes valeurs du taux de codage R. La figure 17 correspond au taux de codage minimal (cas où toutes les lignes des matrices de base BG1 et BG2 sont utilisées), la figure 18 correspond à un taux de codage de valeur ½ (la matrice de base BG1 comporte alors vingt-quatre lignes, tandis que la matrice de base BG2 comporte douze lignes), et la figure 19 correspond à un taux de codage maximal (cas où les matrices de base BG1 et BG2 comportent seulement quatre lignes).

Il apparaît sur les figures 17 à 19 que, pour les configurations basées sur BG1, les nœuds de contrôle de parité présentant un degré de parité égal à dix-neuf sont toujours présents, quel que soit le taux de codage. De façon similaire, pour les configurations basées sur BG2, les nœuds de contrôle de parité présentant un degré de parité égal à huit ou dix sont toujours présents, quel que soit le taux de codage.

Pour une valeur de Z donnée, l'ordonnancement des nœuds de contrôle de la configuration correspondant au taux de codage maximal peut donc être commun à toutes les configurations. Autrement dit, pour une valeur de Z donnée, pour chaque configuration sélectionnée et mémorisée dans la mémoire 20, l'ordonnancement des nœuds de contrôle peut comporter une partie commune à toutes les configurations et une partie spécifique propre à la configuration considérée. La partie commune correspond à l'ordonnancement des nœuds de contrôle de degré élevé ; la partie spécifique correspond à l'ordonnancement des nœuds de contrôle de degré plus faible.

Cette partie commune permet de limiter la taille mémoire nécessaire pour mémoriser les configurations (la partie commune est mémorisée une seule fois pour toutes les configurations avec une même valeur de Z). Ce concept est illustré par les colonnes « Taille config » et « Taille config opt. » des tableaux des figures 13 et 14. Pour chaque configuration sélectionnée, le nombre indiqué dans la colonne « Taille config » est représentatif de la taille totale nécessaire pour mémoriser l'ordonnancement des nœuds de contrôle pour cette configuration. Ce nombre correspond au nombre $N_{conn}$ de connexions de la matrice de parité divisé par le facteur de parallélisation $Z_P$ (il correspond aussi au nombre de connexions de la matrice de base, indiqué dans la colonne « Connexions », multiplié par le rapport $\frac{Z}{Z_P}$ ). Pour une valeur de Z donnée, le nombre indiqué dans la colonne « Taille config » pour le taux de codage maximal (R=0,92) correspond à la taille de la partie commune ; le nombre indiqué dans la colonne « Taille config » pour un taux de codage plus faible correspond à la somme de la taille de la partie commune et de la taille de la partie spécifique. Pour une valeur de Z donnée, le nombre indiqué dans la colonne « Taille config opt. » correspond soit à la taille de la partie commune (pour le taux de codage maximal), soit à la taille de la partie spécifique (pour les taux de codage plus faibles). Pour chaque valeur de Z, il est suffisant de mémoriser la partie commune correspondant au taux de codage maximal (R=0,92) et les parties spécifiques correspondants aux taux de codage inférieurs retenus. Procéder ainsi permet quasiment de diviser par deux la taille mémoire nécessaire pour mémoriser les configurations sélectionnées listées dans les tableaux des figures 13 et 14.

Comme cela a été mentionné précédemment, il est avantageux de choisir un facteur de parallélisation $Z_P$ égal à la plus petite valeur $Z_0$ parmi les valeurs $Z_i$ supportées, car cela permet de limiter la perte de parallélisme tout en offrant une plus grande flexibilité pour résoudre les situations d'aléas de données (« data hazards ») pour les valeurs élevées du facteur d'expansion. Ce choix va à l'encontre d'une idée établie selon laquelle il convient d'utiliser un facteur de parallélisation le plus grand possible. Utiliser un facteur de parallélisation le plus grand possible présente certes un avantage pour limiter la latence du décodage, mais cela offre moins de flexibilité dans la possibilité de résoudre les aléas de données avec un ordonnancement particulier des nœuds de contrôle. Dans le domaine des communications spatiales, les contraintes relatives à la latence du décodage LDPC sont nettement moins exigeantes que pour des communications terrestres.

Architecture multicœur :

L'invention porte également sur un décodeur LDPC avec une architecture multicœur. Cette architecture multicœur est particulièrement bien adaptée à un décodeur LDPC compatible 5G tel que décrit ci-avant. Rien n'empêcherait toutefois d'implémenter un décodeur LDPC avec une architecture multicœur et un jeu de $N_C$ configurations prédéfinies sans que ces configurations ne correspondent à des configurations LDPC 5G.

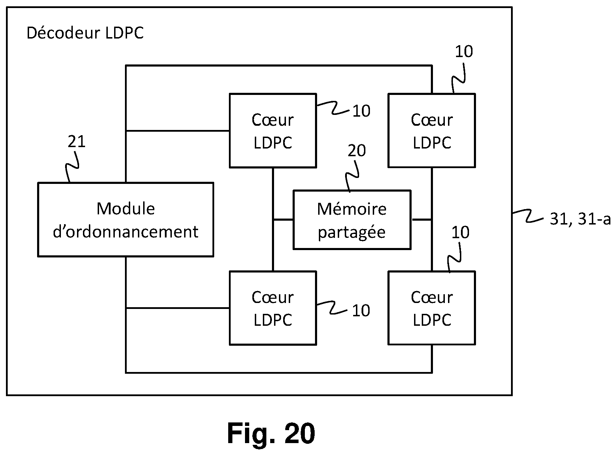

Les figures 20 à 22 présentent trois exemples 31-a, 31-b, 31-c de réalisation d'un décodeur 31 multicœur (dans la suite, le numéro de référence 31 est utilisé pour indiquer de façon générique un décodeur LDPC multicœur selon l'invention).

Dans l'exemple illustré sur la figure 20, le décodeur 31-a comporte un groupe de quatre cœurs 10, chaque cœur étant similaire au cœur 10 du décodeur 30 décrit en référence à la figure 5. La mémoire 20 est partagée entre ces quatre cœurs 10.

Chaque cœur 10 du groupe est adapté pour être dynamiquement configuré avec l'une quelconque des $N_C$ configurations prédéfinies mémorisées dans la mémoire 20 partagée afin de décoder un mot de code LDPC en utilisant cette configuration. Chaque configuration prédéfinie comporte une matrice de parité binaire correspondant à un code LDPC (il s'agit avantageusement de la matrice de parité complète, et non pas seulement d'une sous-matrice permettant de calculer la matrice de parité).

De façon avantageuse plusieurs cœurs du groupe peuvent simultanément décoder chacun un mot de code LDPC différent. A chaque fois qu'un nouveau mot de code doit être décodé par le décodeur 31, un module d'ordonnancement 21 est configuré pour sélectionner un cœur 10 disponible parmi les différents cœurs 10 du groupe, de charger dans la mémoire 13 locale du cœur 10 sélectionné la configuration LDPC devant être utilisée pour décoder le mot de code, et pour lancer le décodage du mot de code par le cœur 10 sélectionné.

A chaque fois qu'un cœur 10 a terminé son processus de décodage d'un mot de code, il envoie une information au module d'ordonnancement 21 pour lui indiquer qu'il est disponible pour décoder un nouveau mot de code.

Cette approche multicœur est particulièrement avantageuse puisqu'elle permet le décodage de plusieurs mots de code en parallèle, c'est-à-dire de façon simultanée. Ainsi, à un instant donné, différents mots de code peuvent être décodés en parallèle par différents cœurs 10 selon différentes configurations.

L'approche multicœur permet également d'optimiser les besoins en ressource mémoire. Le coût en mémoire est réduit car la mémoire 20 est partagée avec tous les cœurs du groupe. Plus le rapport entre la taille de la mémoire 13 locale d'un cœur 10 et la taille de la mémoire 20 partagée entre les cœurs 10 d'un même groupe est petit, et plus le partage de la mémoire 20 entre les différents cœurs 10 est efficace.

Comme on l'a vu précédemment, le décodage d'un mot de code LDPC par un cœur 10 comporte l'exécution d'une ou plusieurs itérations jusqu'à ce qu'un critère d'arrêt soit satisfait, par exemple en fonction des syndromes partiels calculés pour les différentes couches. Il convient également de fixer un nombre maximal d'itérations après lequel le processus de décodage doit s'arrêter.

Il est important de définir correctement ce nombre maximal d'itérations car il a un impact significatif sur les performances du décodeur. En particulier, lorsque le décodeur LDPC est embarqué dans un satellite, les contraintes en termes de puissance de calcul et de consommation énergétique conduisent à choisir un nombre maximal d'itérations relativement faible, généralement de l'ordre de dix. Chaque itération supplémentaire entraine donc un impact de l'ordre de dix pour cent sur les performances.

Pour optimiser les performances du décodeur 31 multicœur, le nombre maximal d'itérations est défini en fonction d'un taux de charge du décodeur. A chaque fois qu'un nouveau mot de code doit être décodé par un cœur 10 du décodeur 31 multicœur, le nombre maximal d'itérations à utiliser pour le décodage de ce nouveau mot de code est calculé.

A un instant donné, le taux de charge du décodeur 31 multicœur est calculé en fonction du nombre de cœurs simultanément occupés à décoder un mot de code LDPC. Par exemple, pour le décodeur 31-a multicœur décrit en référence à la figure 20, le taux de charge est respectivement de 0%, 25%, 50%, 75% ou 100% selon que le nombre de cœur 10 simultanément occupés à décoder un mot de code est égal à zéro, un, deux, trois ou quatre. Le taux de charge est par exemple calculé par le module d'ordonnancement 21.

Pour définir le nombre maximal d'itérations à utiliser pour le décodage d'un nouveau mot de code, le taux de charge du décodeur 31 est calculé juste avant le début du décodage du nouveau mot de code. Le taux de charge peut ou non prendre en compte le fait que le cœur 10 chargé de décoder le nouveau mot de code est occupé. Dans la suite de la description, on se place dans le cas où le taux de charge ne prend pas en compte l'occupation du cœur 10 qui sera chargé du décodage du nouveau mot de code. Dans ce cas, si le taux de charge est égal à 100%, alors le module d'ordonnancement 21 doit attendre qu'un cœur 10 devienne disponible pour lui attribuer le décodage du nouveau mot de code.

A titre d'exemple nullement limitatif, lorsque le taux de charge est inférieur ou égal à 50%, le nombre maximal d'itérations est fixé à dix. Lorsque le taux de charge est strictement supérieur à 50%, alors le nombre maximal d'itérations est fixé à huit.

Rien n'empêcherait toutefois de fixer une autre valeur de seuil pour le taux de charge, ou bien d'autres valeurs du nombre maximal d'itérations en fonction du taux de charge par rapport au seuil.

Il est avantageux d'avoir un nombre maximal d'itérations plus faible lorsque le taux de charge du décodeur 31 multicœur est important. En effet, quand le taux de charge du décodeur 31 est important, il convient de libérer rapidement les cœurs 10 pour pouvoir décoder de nouveaux mots de code. Le fait d'utiliser un nombre maximal d'itérations plus faible permet de limiter le temps de décodage d'un mot de code (tout en acceptant le risque éventuel d'avoir des erreurs dans le décodage).

Dans des modes particuliers de réalisation, le nombre maximal d'itérations peut être défini aussi en fonction du taux de codage R utilisé pour le nouveau mot de code. A titre d'exemple nullement limitatif, lorsque le taux de charge est inférieur ou égal à 50%, le nombre maximal d'itérations est fixé à dix. Lorsque le taux de charge est strictement supérieur à 50% et que le taux de codage est 2/5, alors le nombre maximal d'itérations est fixé à huit. Lorsque le taux de charge est strictement supérieur à 50% et que le taux de codage est 8/9, alors le nombre maximal d'itérations est fixé à six. Là encore, dans des variantes, d'autres valeurs pourraient être envisagé pour le seuil de taux de charge, les taux de codage et/ou les valeurs du nombre maximal d'itérations.

Il est avantageux d'avoir un nombre maximal d'itérations plus faible lorsque le taux de codage du décodeur 31 multicœur est plus important car un taux de codage plus important correspond en général à une convergence plus rapide du processus de décodage.

Dans des modes particuliers de réalisation, le nombre maximal d'itérations peut aussi être défini aussi en fonction de la taille N du nouveau mot de code. Par exemple, plus la taille N du mot de code est élevée et plus le nombre maximal d'itérations peut prendre une valeur faible, car le processus de décodage a tendance à converger plus vite pour les tailles de mot de code élevées.

Dans des modes particuliers de réalisation, le nombre maximal d'itérations peut aussi être défini en fonction d'un rapport signal sur bruit (SNR pour « Signal to Noise Ratio » en anglais) estimé pour le nouveau mot de code. Par exemple, plus la valeur estimée du SNR est élevée, et plus le nombre maximal d'itérations peut prendre une valeur faible. En effet, le processus de décodage a également tendance à converger plus vite pour les valeurs élevées de SNR.

Le nombre maximal d'itérations à utiliser par un cœur 10 pour le décodage d'un nouveau mot de code peut être défini en fonction d'une combinaison de conditions dépendant du taux de charge du décodeur, du taux de codage R à utiliser pour le décodage du nouveau mot de code, de la taille N du nouveau mot de code, ou du niveau estimé de SNR pour le nouveau mot de code.

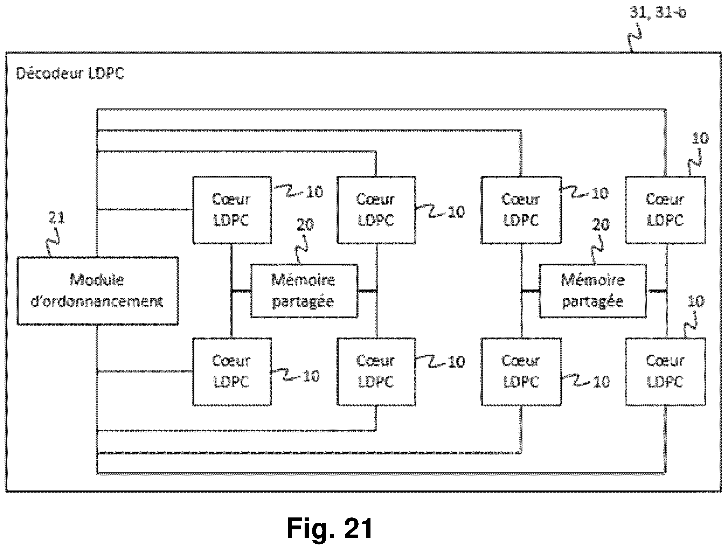

Le décodeur 31-a multicœur décrit ci-avant en référence à la figure 20 comporte un unique groupe de quatre cœurs 10. Rien n'empêcherait toutefois, dans des variantes, de concevoir un décodeur multicœur comportant plusieurs groupes de plusieurs cœurs. Dans l'exemple illustré à la figure 21, le décodeur 31-b multicœur comporte deux groupes de quatre cœurs. Chaque groupe comporte une mémoire 20 partagée entre les quatre cœurs 10 du groupe.

Rien n'empêcherait non plus d'avoir un nombre différent de cœurs 10 au sein de chaque groupe (par exemple seulement deux cœurs, ou bien huit cœurs), ou bien d'avoir des nombres différents de cœurs pour les différents groupes.

Lorsqu'il y a plusieurs groupes de cœurs, le seuil de charge à un instant donné peut être calculé en fonction du nombre total de cœurs simultanément occupés à décoder un mot de code LDPC audit instant, en prenant en compte tous les groupes. Rien n'empêcherait toutefois, dans des variantes, de prendre en compte uniquement le taux de charge du groupe auquel appartient le cœur chargé du décodage du nouveau mot de code, ou bien de définir un taux de charge moyen par groupe. Les différentes méthodes possibles pour calculer le taux de charge et pour définir le nombre maximal d'itérations en fonction du taux de charge ne sont que des variantes de l'invention.

Dans des modes particuliers de réalisation, le module d'ordonnancement 21 est configuré pour ordonnancer les différents cœurs 10 du décodeur 31 multicœur en favorisant, pour le décodage d'un nouveau mot de code, la sélection d'un cœur 10 pour lequel la dernière configuration utilisée par le cœur pour le décodage d'un mot de code précédent est la même que la configuration devant être utilisée pour le décodage du nouveau mot de code.

De telles dispositions permettent d'éviter d'avoir à recharger une nouvelle configuration dans la mémoire 13 locale du cœur 10 pour le décodage du nouveau mot de code. Cela permet d'optimiser le temps de décodage et de limiter les accès concurrents à la mémoire 20 partagée.

Dans ce but, une mémoire tampon peut être utilisée par le module d'ordonnancement 21 pour mémoriser la configuration dernièrement utilisée par chacun des cœurs 10 du décodeur 31 multicœur. Lorsqu'un nouveau mot de code doit être décodé selon une configuration particulière, le module d'ordonnancement 21 est configuré pour identifier, parmi les différents cœurs, si un cœur est disponible pour lequel la configuration dernièrement utilisée est la même que la configuration devant être utilisé pour le décodage du nouveau mot de code. Si un tel cœur est identifié, alors il est préférentiellement sélectionné pour le décodage du nouveau mot de code.

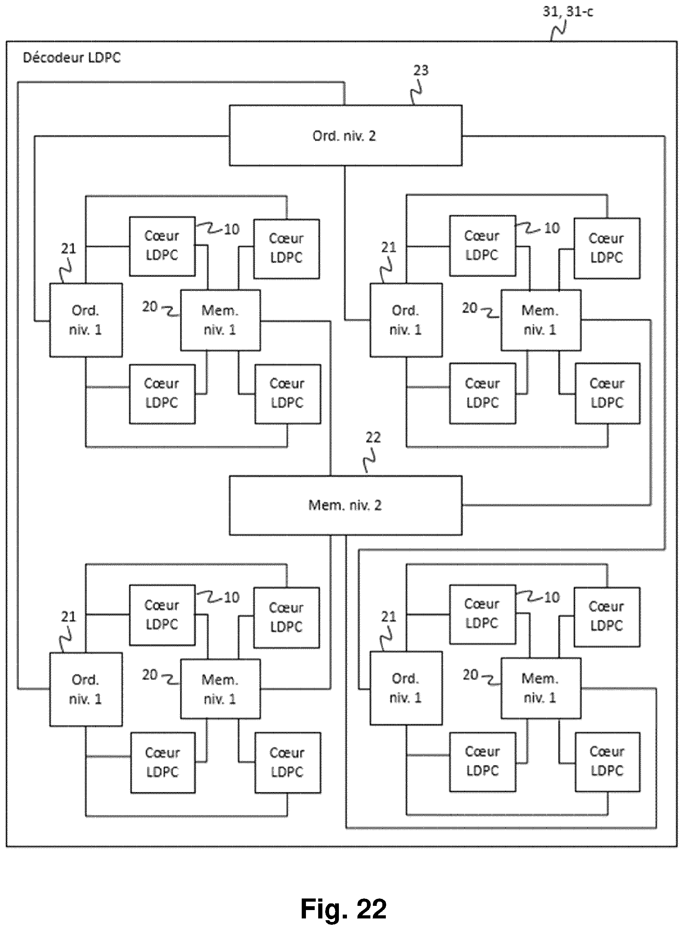

Tel qu'illustré par la figure 22, le concept d'architecture multicœur du décodeur LDPC peut également être généralisé avec plusieurs niveaux de hiérarchie.

La figure 22 représente schématiquement un troisième exemple 31-c de réalisation d'un décodeur LDPC multicœur avec une hiérarchie à deux niveaux. Le décodeur 31-c multicœur comprend quatre groupes de premier niveau comportant chacun quatre cœurs 10 LDPC, une mémoire 20 partagée de premier niveau (« Mem. niv. 1 ») et un module 21 d'ordonnancement de premier niveau (« Ord. niv. 1 ») configuré pour ordonnancer les cœurs 10 du groupe de premier niveau. Le décodeur 31-c multicœur comprend également un groupe de deuxième niveau comprenant les quatre groupes de premier niveau, une mémoire 22 partagée de deuxième niveau (« Mem. niv. 2 ») et un module d'ordonnancement 23 de deuxième niveau (« Ord. niv. 2 ») configuré pour ordonnancer les modules d'ordonnancement 21 de premier niveau.

Le concept illustré à la figure 22 pourrait être étendu à un nombre de niveaux de hiérarchie supérieur à deux. La mémoire 22 partagée de plus haut niveau est une mémoire non volatile qui mémorise l'ensemble de $N_C$ configurations prédéfinies. Différents groupes de configurations peuvent être dynamiquement chargés dans les mémoires 20 partagées de niveau inférieur. La taille d'une mémoire partagée peut être d'autant plus importante que son niveau de hiérarchie est élevé.

Résultats de tests :

Des tests ont été réalisés pour comparer un décodeur 5G conventionnel réalisé en FPGA (Xilinx) avec un décodeur LDPC selon l'invention, pour le décodage d'un mot de code selon certaines configurations particulières.

Il a été observé que les valeurs de débit codé sont nettement plus homogènes avec le décodeur selon l'invention pour les différentes configurations testées (le débit codé peut être mesuré en MLLR/s, un MLLR/s correspond à un débit de $10^6$ valeurs de LLR par seconde). Le ratio entre le débit codé le plus élevé et le débit codé le plus faible est de l'ordre de cinq pour le décodeur 5G conventionnel, contre un ratio de l'ordre de 2.5 avec un décodeur LDPC selon l'invention.

Pour les taux de codage élevés (par exemple pour une configuration {K=5632, R=8/9, Z=256}), il a été observé que les besoins en termes de mémoire sont environ 1.25 fois plus élevés et les besoins en logique sont environ 2 fois plus élevés pour le décodeur 5G conventionnel par rapport au décodeur LDPC selon l'invention. Les besoins en mémoire peuvent être mesurés en BRAM par MLLR/s ; un BRAM correspond à un bloc RAM de 36 kbits. Les besoins en logique peuvent être mesurés en LUT6 par MLLR/s ; un LUT6 est une ressource FPGA correspondant à une table de recherche (« Look-Up Table ») à six entrées.

Pour les taux de codage faibles (par exemple pour une configuration {K=5632, R=2/5, Z=256}), il a été observé que les besoins en termes de mémoire sont environ 2.0 fois plus élevés et les besoins en logique sont environ 3.6 fois plus élevés pour le décodeur 5G conventionnel par rapport au décodeur LDPC selon l'invention.

Il convient de noter que les résultats ci-dessus ont été obtenus pour un taux de parallélisation optimal pour le décodeur 5G conventionnel. Avec une distribution plus hétérogène des configurations testées, le décodeur selon l'invention aurait surclassé le décodeur conventionnel de façon encore plus significative.

La description ci-avant illustre clairement que, par ses différentes caractéristiques et leurs avantages, la présente invention atteint les objectifs fixés. En particulier, le décodeur selon l'invention est compatible avec la 5G tout en restant particulièrement bien adapté et très performant pour des communications satellitaires.

Il est à noter que les modes de réalisation considérés ci-dessus ont été décrits à titre d'exemples non limitatifs, et que d'autres variantes sont par conséquent envisageables. En particulier, la valeur du nombre $N_C$ ou les exemples spécifiques de configurations LDPC retenues ne sont en rien limitatifs. D'autres configurations pourraient être sélectionnées pour former un sous-groupe strict de l'ensemble des configurations LDPC 5G définies par la spécification 3GPP TS 38.212.

De façon similaire, différentes valeurs peuvent être envisagées pour le nombre de cœurs ou le nombre de groupes de cœurs formant le décodeur LDPC. Aussi, différentes méthodes peuvent être envisagées pour définir le nombre maximal d'itérations en fonction d'un taux de charge du décodeur. Les différents choix possibles pour ces valeurs ou ces méthodes ne constituent que des variantes de l'invention.

L'invention a été décrite en considérant un décodeur LDPC destiné à être embarqué dans un satellite en orbite autour de la Terre. Rien n'exclut cependant, suivant d'autres exemples, de considérer d'autres domaines spécifiques dans lequel il pourrait être intéressant d'avoir un décodeur LDPC compatible avec la 5G sans nécessairement supporter toutes les configurations LDPC 5G.

La présente demande porte d'une part sur une architecture multicœur pour un décodeur LDPC, et d'autre part sur le fait d'obtenir un décodeur LDPC compatible avec la 5G (c'est-à-dire compatible avec au moins certaines configurations LDPC 5G) qui reste adapté et performant pour des communications satellitaires. Ces deux aspects peuvent toutefois être appliqués indépendamment l'un de l'autre : l'architecture multicœur proposée est une invention à part entière, qu'elle soit utilisée ou non pour un décodeur LDPC compatible avec la 5G. L'architecture multicœur proposée est toutefois particulièrement bien adaptée pour concevoir un décodeur LDPC compatible 5G adapté pour les communications satellitaires.

## Revendications

1. Décodeur (31) multicœur pour le décodage de mots de code de contrôle de parité de faible densité, ou code LDPC,

   ledit décodeur (31) multicœur comportant au moins un groupe de plusieurs cœurs (10), plusieurs de ces cœurs (10) pouvant simultanément décoder chacun un mot de code LDPC différent,
   ledit au moins un groupe comportant une mémoire (20) partagée entre les différents cœurs (10) dans laquelle est mémorisé un nombre $N_C$ de configurations prédéfinies, chaque configuration prédéfinie étant associée à une matrice de parité correspondant à un code LDPC,
   chaque cœur (10) étant adapté pour être dynamiquement configuré avec l'une quelconque des $N_C$ configurations prédéfinies mémorisées dans la mémoire (20) partagée afin de décoder un mot de code LDPC en utilisant cette configuration,
   **caractérisé par** :

   les matrices de parité associées aux $N_C$ configurations prédéfinies étant précalculées et
   mémorisées dans la mémoire (20) partagée.

2. Décodeur (31) multicœur selon la revendication 1 dans lequel les $N_C$ configurations prédéfinies forment un sous-groupe, au sens strict, des configurations LDPC 5G définies dans le standard 3GPP TS 38.212.

3. Décodeur (31) multicœur selon l'une quelconque des revendications 1 à 2 dans lequel chaque cœur (10) comporte une mémoire (13) locale de configuration dont la taille est au moins égale à la plus grande des tailles des $N_C$ configurations prédéfinies mémorisées dans la mémoire (20) partagée, et la taille de la mémoire (13) locale est au moins quatre fois plus petite que la taille de la mémoire (20) partagée.

4. Décodeur (31) multicœur selon l'une quelconque des revendications 1 à 3 dans lequel le nombre $N_C$ de configurations prédéfinies mémorisées dans la mémoire (20) partagée est compris entre 8 et 512, voire entre 8 et 256, voire même entre 8 et 128.

5. Décodeur (31) selon l'une quelconque des revendications 1 à 4 dans lequel chacune des $N_C$ configurations comporte un ordonnancement optimisé de nœuds de contrôle de parité du cœur (10), ledit ordonnancement étant défini en fonction d'un degré de parité de chaque nœud de contrôle de parité pour la configuration considérée.

6. Décodeur (31) multicœur selon l'une quelconque des revendications 1 à 5 dans lequel le décodage d'un mot de code LDPC par un cœur (10) comporte l'exécution d'une ou plusieurs itérations jusqu'à ce qu'un critère d'arrêt soit satisfait, ledit critère d'arrêt comportant une vérification si un nombre maximal d'itérations est atteint et, pour un nouveau mot de code à décoder par un cœur (10), le nombre maximal d'itérations est défini en fonction d'un taux de charge du décodeur (31) multicœur.

7. Décodeur (31) multicœur selon la revendication 6 dans lequel le taux de charge à un instant donné est calculé en fonction d'un nombre de cœurs (10) simultanément occupés à décoder un mot de code LDPC audit instant.

8. Décodeur (31) multicœur selon l'une quelconque des revendications 6 à 7 dans lequel le nombre maximal d'itérations est défini aussi en fonction de la taille du nouveau mot de code.

9. Décodeur (31) multicœur selon l'une quelconque des revendications 6 à 8 dans lequel le nombre maximal d'itérations est défini aussi en fonction d'un taux de codage utilisé pour le nouveau mot de code.

10. Décodeur (31) multicœur selon l'une quelconque des revendications 6 à 9 dans lequel le nombre maximal d'itérations est défini aussi en fonction d'un rapport signal sur bruit estimé pour le nouveau mot de code.

11. Décodeur (31) multicœur selon l'une quelconque des revendications 1 à 10, comportant un module d'ordonnancement (21) adapté pour ordonnancer les cœurs (10) en favorisant, pour le décodage d'un nouveau mot de code, la sélection d'un cœur (10) pour lequel la dernière configuration utilisée par le cœur (10) pour le décodage d'un mot de code précédent est la même que la configuration devant être utilisée pour le décodage du nouveau mot de code.

12. Dispositif de réception comportant un décodeur (31) multicœur selon l'une quelconque des revendications 1 à 11.

13. Satellite comportant un dispositif de réception selon la revendication 12.

**Patentansprüche**

1. Mehrkern-Decoder (31) zum Decodieren von Paritätsprüfworten niedriger Dichte, oder LDPC-Code,

   wobei der Mehrkern-Decoder (31) mindestens eine Gruppe mehrerer Kerne (10) umfasst, wobei mehrere dieser Kerne (10) gleichzeitig jeweils ein unterschiedliches LDPC-Codewort decodieren können,
   wobei die mindestens eine Gruppe einen Speicher (20) aufweist, der zwischen den verschiedenen Kernen (10) geteilt ist, in dem eine Anzahl $N_C$ vordefinierter Konfigurationen gespeichert ist, wobei jede vordefinierte Konfiguration einer Paritätsmatrix zugeordnet ist, die einem LDPC-Code entspricht,
   wobei jeder Kern (10) so ausgelegt ist, dass er dynamisch mit einer beliebigen der in dem geteilten Speicher (20) gespeicherten vordefinierten $N_C$-Konfigurationen konfiguriert werden kann, um ein LDPC-Codewort unter Verwendung dieser Konfiguration zu decodieren,
   **dadurch gekennzeichnet:**
   **dass** die Paritätsmatrizen, die den vordefinierten $N_C$-Konfigurationen zugeordnet sind, vorberechnet und in dem geteilten Speicher (20) gespeichert werden.

2. Mehrkern-Decoder (31) nach Anspruch 1, bei dem die vordefinierten $N_C$-Konfigurationen eine Untergruppe im engeren Sinne der in dem Standard 3GPP TS 38.212 definierten 5G-LDPC-Konfigurationen bilden.

3. Mehrkern-Decoder (31) nach einem der Ansprüche 1 bis 2, wobei jeder Kern (10) einen lokalen Konfigurationsspeicher (13) aufweist, dessen Größe mindestens der größten der in dem geteilten Speicher (20) gespeicherten Größen der vordefinierten $N_C$-Konfigurationen entspricht, und die Größe des lokalen Speichers (13) mindestens viermal kleiner ist als die Größe des geteilten Speichers (20).

4. Mehrkern-Decoder (31) nach einem der Ansprüche 1 bis 3, wobei die Anzahl $N_C$ der in dem geteilten Speicher (20) gespeicherten vordefinierten Konfigurationen zwischen 8 und 512, oder zwischen 8 und 256, oder sogar zwischen 8 und 128 liegt.

5. Decoder (31) nach einem der Ansprüche 1 bis 4, wobei jede der $N_C$-Konfigurationen eine optimierte Anordnung von Paritätskontrollknoten des Kerns (10) aufweist, wobei die Anordnung in Abhängigkeit von einem Paritätsgrad jedes Paritätskontrollknotens für die betrachtete Konfiguration definiert ist.

6. Mehrkern-Decoder (31) nach einem der Ansprüche 1 bis 5, wobei das Decodieren eines LDPC-Codeworts durch einen Kern (10) das Ausführen einer oder mehrerer Iterationen umfasst, bis ein Abbruchkriterium erfüllt ist, wobei das Abbruchkriterium eine Überprüfung umfasst, ob eine maximale Anzahl von Iterationen erreicht ist, und wobei für ein neues Codewort, das von einem Kern (10) decodiert werden soll, die maximale Anzahl von Iterationen in Abhängigkeit von einer Auslastungsrate des Mehrkern-Decoders (31) definiert ist.

7. Mehrkern-Decoder (31) nach Anspruch 6, wobei die Auslastungsrate zu einem bestimmten Zeitpunkt in Abhängigkeit von einer Anzahl von Kernen (10) berechnet wird, die zu diesem Zeitpunkt gleichzeitig mit dem Decodieren eines LDPC-Codeworts beschäftigt sind.

8. Mehrkern-Decoder (31) nach einem der Ansprüche 6 bis 7, wobei die maximale Anzahl von Iterationen auch in Abhängigkeit von der Größe des neuen Codeworts definiert ist.

9. Mehrkern-Decoder (31) nach einem der Ansprüche 6 bis 8, wobei die maximale Anzahl von Iterationen auch in Abhängigkeit von einer für das neue Codewort verwendeten Kodierrate definiert ist.

10. Mehrkern-Decoder (31) nach einem der Ansprüche 6 bis 9, wobei die maximale Anzahl von Iterationen auch in Abhängigkeit von einem geschätzten Signal-zu-RauschVerhältnis für das neue Codewort definiert ist.

11. Mehrkern-Decoder (31) nach einem der Ansprüche 1 bis 10, mit einem Anordnungsmodul (21), das dazu ausgelegt ist, die Kerne (10) so anzuordnen, dass es für das Decodieren eines neuen Codeworts die Auswahl eines Kerns (10) bevorzugt, bei dem die zuletzt von dem Kern (10) für das Decodieren eines vorhergehenden Codeworts verwendete Konfiguration dieselbe ist wie die für das Decodieren des neuen Codeworts zu verwendende Konfiguration.

12. Empfangsvorrichtung, die einen Mehrkern-Decoder (31) gemäß einem der Ansprüche 1 bis 11 aufweist.

13. Satellit, der eine Empfangsvorrichtung gemäß Anspruch 12 aufweist.

## Claims

1. Multicore decoder (31) for decoding low-density parity-check, or LDPC, code words,

   said multi-core decoder (31) comprising at least one group of several cores (10), several of these cores (10) each simultaneously capable of decoding a different LDPC code word,
   said at least one group comprising a memory (20) shared between the various cores (10) in which a number $N_C$ of predefined configurations is stored, each predefined configuration being associated with a parity matrix corresponding to an LDPC code,
   each core (10) being adapted to be dynamically configured with any one of the $N_C$ predefined configurations stored in the memory (20) in order to decode an LDPC code word using this configuration;
   **characterized by**:
   the parity matrices associated with the $N_C$ predefined configurations being precomputed and stored in the shared memory (20).

2. Multicore decoder (31) according to claim 1, wherein the $N_C$ predefined configurations form a subgroup, in the strict sense, of the 5G LDPC configurations defined in the 3GPP TS 38.212 standard.

3. Multicore decoder (31) according to either one of claims 1 to 2, wherein each core (10) includes a local configuration memory (13) the size of which is at least equal to the largest of the sizes of the $N_C$ predefined configurations stored in the shared memory (20), and the size of the local memory (13) is at least four times smaller than the size of the shared memory (20).

4. Decoder (31) according to any one of claims 1 to 3, wherein the number $N_C$ of predefined configurations stored in the shared memory (20) is between 8 and 512, or even between 8 and 256, or even between 8 and 128.

5. Decoder (31) according to any one of claims 1 to 4, wherein each of the $N_C$ configurations comprises an optimized scheduling of parity check nodes of the core (10), said scheduling being defined according to a degree of parity of each parity check node for the configuration in question.

6. Multicore decoder (31) according to any one of claims 1 to 5 wherein decoding an LDPC code word by a core (10) comprises executing one or more iterations until a stop criterion is met, said stop criterion comprising checking whether a maximum number of iterations is reached and, for a new code word to be decoded by a core (10), the maximum number of iterations is defined according to a load on the multicore decoder (31).

7. Multi-core decoder (31) according to claim 6, wherein the load at a given time is calculated according to a number of cores (10) simultaneously occupied decoding an LDPC code word at said time.

8.  Multicore decoder (31) according to any one of claims 6 to 7, wherein the maximum number of iterations is also defined according to the size of the new code word.

9.  Multicore decoder (31) according to any one of claims 6 to 8, wherein the maximum number of iterations is also defined according to an encoding rate used for the new code word.

10. Multicore decoder (31) according to any one of claims 6 to 9, wherein the maximum number of iterations is also defined according to an estimated signal-to-noise ratio for the new code word.

11. Multi-core decoder (31) according to any one of claims 1 to 10, comprising a scheduling module (21) suitable for scheduling the cores (10) by favoring, for decoding a new code word, the selection of a core (10) for which the last configuration used by the core (10) for decoding a previous code word is the same as the configuration to be used for decoding the new code word.

12. Receiving device comprising a decoder (31) according to any one of claims 1 to 11.

13. Satellite comprising a receiving device according to claim 12.

$$
H \quad
\begin{Bmatrix}
1 & 0 & 0 & 0 & \cdots & 0 & 0 & 1 & \cdots & 0 & 0 & 0 \\
0 & 0 & 1 & \cdots & & 1 & 0 & 0 & \cdots & & 0 & 0 \\
\vdots & \vdots & \vdots & & & \vdots & \vdots & \vdots & & & \vdots & \vdots \\
0 & 0 & 0 & \cdots & & 1 & 0 & 1 & \cdots & & 0 & 1
\end{Bmatrix}
$$

N

M

**Fig. 1**

G

**Fig. 2**

B

$$
\left\{
\begin{array}{cccccccccc}
0 & 92 & -1 & 0 & \cdots & & \cdots & 54 & -1 & -1 & -1 \\
-1 & 0 & 0 & 17 & \cdots & & \cdots & -1 & 0 & -1 & -1 \\
\vdots & \vdots & \vdots & \vdots & & & & \vdots & \vdots & \vdots & \vdots \\
-1 & 0 & 12 & -1 & \cdots & & 28 & \cdots & -1 & 0 & -1 & 0
\end{array}
\right\}
$$

**Fig. 3**

100

Début de traitement d'une nouvelle itération à partir de la première couche

Calcul des messages $\alpha_{n,m}$ — 111

Calcul des messages $\beta_{m,n}$ — 112

Calcul des variables d'estimation a posteriori $\gamma_n$ — 113

Calcul du syndrome partiel — 114

— 110

Passage à la couche suivante

Fin de l'itération ? — 120

Non

Oui

Le critère d'arrêt est satisfait ? — 130

Passage à l'itération suivante

Oui

Non

## Fig. 4

**Fig. 5**

**Fig. 6**

Empreinte mémoire pour les messages ($\beta_{m,n}$)

BG1 – $Z_p$ = 32

| | 32 | 64 | 96 | 128 | 160 | 192 | 224 | 256 | 288 | 320 | 352 | 384 |
|---|---|---|---|---|---|---|---|---|---|---|---|---|
| 0,92 | 7 | 8 | 8 | 9 | 9 | 9 | 10 | 10 | 10 | 10 | 10 | 10 |
| 0,88 | 7 | 8 | 8 | 9 | 9 | 9 | 10 | 10 | 10 | 10 | 10 | 10 |
| 0,85 | 7 | 8 | 9 | 9 | 9 | 10 | 10 | 10 | 10 | 10 | 10 | 11 |
| 0,81 | 7 | 8 | 9 | 9 | 9 | 10 | 10 | 10 | 10 | 10 | 11 | 11 |
| 0,79 | 7 | 8 | 9 | 9 | 10 | 10 | 10 | 10 | 10 | 11 | 11 | 11 |
| 0,76 | 7 | 8 | 9 | 9 | 10 | 10 | 10 | 10 | 10 | 11 | 11 | 11 |
| 0,73 | 7 | 8 | 9 | 9 | 10 | 10 | 10 | 10 | 11 | 11 | 11 | 11 |
| 0,71 | 8 | 9 | 9 | 10 | 10 | 10 | 10 | 11 | 11 | 11 | 11 | 11 |
| 0,69 | 8 | 9 | 9 | 10 | 10 | 10 | 10 | 11 | 11 | 11 | 11 | 11 |
| 0,67 | 8 | 9 | 9 | 10 | 10 | 10 | 10 | 11 | 11 | 11 | 11 | 11 |
| 0,65 | 8 | 9 | 9 | 10 | 10 | 10 | 11 | 11 | 11 | 11 | 11 | 11 |
| 0,63 | 8 | 9 | 9 | 10 | 10 | 10 | 11 | 11 | 11 | 11 | 11 | 11 |
| 0,61 | 8 | 9 | 9 | 10 | 10 | 10 | 11 | 11 | 11 | 11 | 11 | 11 |
| 0,59 | 8 | 9 | 9 | 10 | 10 | 10 | 11 | 11 | 11 | 11 | 11 | 11 |
| 0,58 | 8 | 9 | 10 | 10 | 10 | 11 | 11 | 11 | 11 | 11 | 11 | 12 |
| 0,56 | 8 | 9 | 10 | 10 | 10 | 11 | 11 | 11 | 11 | 11 | 11 | 12 |
| 0,55 | 8 | 9 | 10 | 10 | 10 | 11 | 11 | 11 | 11 | 11 | 12 | 12 |
| 0,54 | 8 | 9 | 10 | 10 | 10 | 11 | 11 | 11 | 11 | 11 | 12 | 12 |
| 0,52 | 8 | 9 | 10 | 10 | 10 | 11 | 11 | 11 | 11 | 11 | 12 | 12 |
| 0,51 | 8 | 9 | 10 | 10 | 11 | 11 | 11 | 11 | 11 | 12 | 12 | 12 |
| 0,50 | 8 | 9 | 10 | 10 | 11 | 11 | 11 | 11 | 11 | 12 | 12 | 12 |
| 0,49 | 8 | 9 | 10 | 10 | 11 | 11 | 11 | 11 | 11 | 12 | 12 | 12 |
| 0,48 | 8 | 9 | 10 | 10 | 11 | 11 | 11 | 11 | 11 | 12 | 12 | 12 |
| 0,47 | 8 | 9 | 10 | 10 | 11 | 11 | 11 | 11 | 11 | 12 | 12 | 12 |
| 0,46 | 8 | 9 | 10 | 10 | 11 | 11 | 11 | 11 | 12 | 12 | 12 | 12 |
| 0,45 | 8 | 9 | 10 | 10 | 11 | 11 | 11 | 11 | 12 | 12 | 12 | 12 |
| 0,44 | 8 | 9 | 10 | 10 | 11 | 11 | 11 | 11 | 12 | 12 | 12 | 12 |
| 0,43 | 8 | 9 | 10 | 10 | 11 | 11 | 11 | 11 | 12 | 12 | 12 | 12 |
| 0,42 | 8 | 9 | 10 | 10 | 11 | 11 | 11 | 11 | 12 | 12 | 12 | 12 |
| 0,42 | 8 | 9 | 10 | 10 | 11 | 11 | 11 | 11 | 12 | 12 | 12 | 12 |
| 0,41 | 9 | 10 | 10 | 11 | 11 | 11 | 11 | 12 | 12 | 12 | 12 | 12 |
| 0,40 | 9 | 10 | 10 | 11 | 11 | 11 | 11 | 12 | 12 | 12 | 12 | 12 |
| 0,39 | 9 | 10 | 10 | 11 | 11 | 11 | 11 | 12 | 12 | 12 | 12 | 12 |
| 0,39 | 9 | 10 | 10 | 11 | 11 | 11 | 11 | 12 | 12 | 12 | 12 | 12 |
| 0,38 | 9 | 10 | 10 | 11 | 11 | 11 | 11 | 12 | 12 | 12 | 12 | 12 |
| 0,37 | 9 | 10 | 10 | 11 | 11 | 11 | 11 | 12 | 12 | 12 | 12 | 12 |
| 0,37 | 9 | 10 | 10 | 11 | 11 | 11 | 11 | 12 | 12 | 12 | 12 | 12 |
| 0,36 | 9 | 10 | 10 | 11 | 11 | 11 | 12 | 12 | 12 | 12 | 12 | 12 |
| 0,35 | 9 | 10 | 10 | 11 | 11 | 11 | 12 | 12 | 12 | 12 | 12 | 12 |
| 0,35 | 9 | 10 | 10 | 11 | 11 | 11 | 12 | 12 | 12 | 12 | 12 | 12 |
| 0,34 | 9 | 10 | 10 | 11 | 11 | 11 | 12 | 12 | 12 | 12 | 12 | 12 |
| 0,34 | 9 | 10 | 10 | 11 | 11 | 11 | 12 | 12 | 12 | 12 | 12 | 12 |
| 0,33 | 9 | 10 | 10 | 11 | 11 | 11 | 12 | 12 | 12 | 12 | 12 | 12 |

## Fig. 7

Empreinte mémoire pour les messages (β)
BG1 - Zp = 32

Fig. 8

Empreinte mémoire pour les messages (β)
BG2 - Zp = 32

Fig. 9

EP 4 595 233 B1

## Empreinte mémoire pour les APP ($\gamma_n$)
### BG1 – $Z_p$ = 32

| R | 32 | 64 | 96 | 128 | 160 | 192 | 224 | 256 | 288 | 320 | 352 | 384 |
|---|----|----|----|-----|-----|-----|-----|-----|-----|-----|-----|-----|
| 0,92 | 5 | 6 | 7 | 7 | 8 | 8 | 8 | 8 | 8 | 9 | 9 | 9 |
| 0,88 | 5 | 6 | 7 | 7 | 8 | 8 | 8 | 8 | 8 | 9 | 9 | 9 |
| 0,85 | 5 | 6 | 7 | 7 | 8 | 8 | 8 | 8 | 8 | 9 | 9 | 9 |
| 0,81 | 5 | 6 | 7 | 7 | 8 | 8 | 8 | 8 | 9 | 9 | 9 | 9 |
| 0,79 | 5 | 6 | 7 | 7 | 8 | 8 | 8 | 8 | 9 | 9 | 9 | 9 |
| 0,76 | 5 | 6 | 7 | 7 | 8 | 8 | 8 | 8 | 9 | 9 | 9 | 9 |
| 0,73 | 5 | 6 | 7 | 7 | 8 | 8 | 8 | 8 | 9 | 9 | 9 | 9 |
| 0,71 | 6 | 7 | 7 | 8 | 8 | 8 | 8 | 9 | 9 | 9 | 9 | 9 |
| 0,69 | 6 | 7 | 7 | 8 | 8 | 8 | 8 | 9 | 9 | 9 | 9 | 9 |
| 0,67 | 6 | 7 | 7 | 8 | 8 | 8 | 8 | 9 | 9 | 9 | 9 | 9 |
| 0,65 | 6 | 7 | 7 | 8 | 8 | 8 | 8 | 9 | 9 | 9 | 9 | 9 |
| 0,63 | 6 | 7 | 7 | 8 | 8 | 8 | 9 | 9 | 9 | 9 | 9 | 9 |
| 0,61 | 6 | 7 | 7 | 8 | 8 | 8 | 9 | 9 | 9 | 9 | 9 | 9 |
| 0,59 | 6 | 7 | 7 | 8 | 8 | 8 | 9 | 9 | 9 | 9 | 9 | 9 |
| 0,58 | 6 | 7 | 7 | 8 | 8 | 8 | 9 | 9 | 9 | 9 | 9 | 9 |
| 0,56 | 6 | 7 | 7 | 8 | 8 | 8 | 9 | 9 | 9 | 9 | 9 | 9 |
| 0,55 | 6 | 7 | 7 | 8 | 8 | 8 | 9 | 9 | 9 | 9 | 9 | 9 |
| 0,54 | 6 | 7 | 8 | 8 | 8 | 9 | 9 | 9 | 9 | 9 | 9 | 10 |
| 0,52 | 6 | 7 | 8 | 8 | 8 | 9 | 9 | 9 | 9 | 9 | 9 | 10 |
| 0,51 | 6 | 7 | 8 | 8 | 8 | 9 | 9 | 9 | 9 | 9 | 9 | 10 |
| 0,50 | 6 | 7 | 8 | 8 | 8 | 9 | 9 | 9 | 9 | 9 | 9 | 10 |
| 0,49 | 6 | 7 | 8 | 8 | 8 | 9 | 9 | 9 | 9 | 9 | 10 | 10 |
| 0,48 | 6 | 7 | 8 | 8 | 8 | 9 | 9 | 9 | 9 | 9 | 10 | 10 |
| 0,47 | 6 | 7 | 8 | 8 | 8 | 9 | 9 | 9 | 9 | 9 | 10 | 10 |
| 0,46 | 6 | 7 | 8 | 8 | 8 | 9 | 9 | 9 | 9 | 9 | 10 | 10 |
| 0,45 | 6 | 7 | 8 | 8 | 8 | 9 | 9 | 9 | 9 | 9 | 10 | 10 |
| 0,44 | 6 | 7 | 8 | 8 | 9 | 9 | 9 | 9 | 9 | 10 | 10 | 10 |
| 0,43 | 6 | 7 | 8 | 8 | 9 | 9 | 9 | 9 | 9 | 10 | 10 | 10 |
| 0,42 | 6 | 7 | 8 | 8 | 9 | 9 | 9 | 9 | 9 | 10 | 10 | 10 |
| 0,42 | 6 | 7 | 8 | 8 | 9 | 9 | 9 | 9 | 9 | 10 | 10 | 10 |
| 0,41 | 6 | 7 | 8 | 8 | 9 | 9 | 9 | 9 | 9 | 10 | 10 | 10 |
| 0,40 | 6 | 7 | 8 | 8 | 9 | 9 | 9 | 9 | 10 | 10 | 10 | 10 |
| 0,39 | 6 | 7 | 8 | 8 | 9 | 9 | 9 | 9 | 10 | 10 | 10 | 10 |
| 0,39 | 6 | 7 | 8 | 8 | 9 | 9 | 9 | 9 | 10 | 10 | 10 | 10 |
| 0,38 | 6 | 7 | 8 | 8 | 9 | 9 | 9 | 9 | 10 | 10 | 10 | 10 |
| 0,37 | 6 | 7 | 8 | 8 | 9 | 9 | 9 | 9 | 10 | 10 | 10 | 10 |
| 0,37 | 6 | 7 | 8 | 8 | 9 | 9 | 9 | 9 | 10 | 10 | 10 | 10 |
| 0,36 | 6 | 7 | 8 | 8 | 9 | 9 | 9 | 9 | 10 | 10 | 10 | 10 |
| 0,35 | 6 | 7 | 8 | 8 | 9 | 9 | 9 | 9 | 10 | 10 | 10 | 10 |
| 0,35 | 7 | 8 | 8 | 9 | 9 | 9 | 9 | 10 | 10 | 10 | 10 | 10 |
| 0,34 | 7 | 8 | 8 | 9 | 9 | 9 | 9 | 10 | 10 | 10 | 10 | 10 |
| 0,34 | 7 | 8 | 8 | 9 | 9 | 9 | 9 | 10 | 10 | 10 | 10 | 10 |
| 0,33 | 7 | 8 | 8 | 9 | 9 | 9 | 9 | 10 | 10 | 10 | 10 | 10 |

## Fig. 10

Empreinte mémoire pour les APP (γ)
BG1 - Zp = 32

**Fig. 11**

Empreinte mémoire pour les APP (γ)
BG2 - Zp = 32

Fig. 12

| | ID | Z | CR | Kb | K | Connexions | Taille config | Taille config opt. |
|---|---|---|---|---|---|---|---|---|
| | 0 | 352 | 0,92 | 22 | 7744 | 76 | 836 | 836 |
| | 1 | 352 | 0,81 | 22 | 7744 | 96 | 1056 | 220 |
| | 2 | 352 | 0,76 | 22 | 7744 | 113 | 1243 | 407 |
| | 3 | 352 | 0,67 | 22 | 7744 | 144 | 1584 | 748 |
| | 4 | 320 | 0,92 | 22 | 7040 | 76 | 760 | 760 |
| | 5 | 320 | 0,81 | 22 | 7040 | 96 | 960 | 200 |
| | 6 | 320 | 0,76 | 22 | 7040 | 113 | 1130 | 370 |
| | 7 | 320 | 0,67 | 22 | 7040 | 144 | 1440 | 680 |
| | 8 | 288 | 0,92 | 22 | 6336 | 76 | 684 | 684 |
| | 9 | 288 | 0,81 | 22 | 6336 | 96 | 864 | 180 |
| | 10 | 288 | 0,76 | 22 | 6336 | 113 | 1017 | 333 |
| | 11 | 288 | 0,67 | 22 | 6336 | 144 | 1296 | 612 |
| | 12 | 288 | 0,50 | 22 | 6336 | 210 | 1890 | 1206 |
| | 13 | 256 | 0,92 | 22 | 5632 | 76 | 608 | 608 |
| | 14 | 256 | 0,81 | 22 | 5632 | 96 | 768 | 160 |
| | 15 | 256 | 0,76 | 22 | 5632 | 113 | 904 | 296 |
| | 16 | 256 | 0,67 | 22 | 5632 | 144 | 1152 | 544 |
| | 17 | 256 | 0,50 | 22 | 5632 | 210 | 1680 | 1072 |
| | 18 | 256 | 0,42 | 22 | 5632 | 255 | 2040 | 1432 |
| | 19 | 224 | 0,92 | 22 | 4928 | 76 | 532 | 532 |
| | 20 | 224 | 0,81 | 22 | 4928 | 96 | 672 | 140 |
| | 21 | 224 | 0,76 | 22 | 4928 | 113 | 791 | 259 |
| | 22 | 224 | 0,67 | 22 | 4928 | 144 | 1008 | 476 |
| | 23 | 224 | 0,50 | 22 | 4928 | 210 | 1470 | 938 |
| | 24 | 224 | 0,42 | 22 | 4928 | 255 | 1785 | 1253 |
| BG1 | 25 | 192 | 0,92 | 22 | 4224 | 76 | 456 | 456 |
| | 26 | 192 | 0,81 | 22 | 4224 | 96 | 576 | 120 |
| | 27 | 192 | 0,76 | 22 | 4224 | 113 | 678 | 222 |
| | 28 | 192 | 0,67 | 22 | 4224 | 144 | 864 | 408 |
| | 29 | 192 | 0,50 | 22 | 4224 | 210 | 1260 | 804 |
| | 30 | 192 | 0,42 | 22 | 4224 | 255 | 1530 | 1074 |
| | 31 | 160 | 0,92 | 22 | 3520 | 76 | 380 | 380 |
| | 32 | 160 | 0,81 | 22 | 3520 | 96 | 480 | 100 |
| | 33 | 160 | 0,76 | 22 | 3520 | 113 | 565 | 185 |
| | 34 | 160 | 0,69 | 22 | 3520 | 144 | 720 | 340 |
| | 35 | 128 | 0,92 | 22 | 2816 | 76 | 304 | 304 |
| | 36 | 128 | 0,81 | 22 | 2816 | 96 | 384 | 80 |
| | 37 | 128 | 0,76 | 22 | 2816 | 113 | 452 | 148 |
| | 38 | 128 | 0,69 | 22 | 2816 | 144 | 576 | 272 |
| | 39 | 96 | 0,92 | 22 | 2112 | 76 | 228 | 228 |
| | 40 | 96 | 0,81 | 22 | 2112 | 96 | 288 | 60 |
| | 41 | 96 | 0,76 | 22 | 2112 | 113 | 339 | 111 |
| | 42 | 96 | 0,69 | 22 | 2112 | 144 | 432 | 204 |
| | 43 | 64 | 0,92 | 22 | 1408 | 76 | 152 | 152 |
| | 44 | 64 | 0,81 | 22 | 1408 | 96 | 192 | 40 |
| | 45 | 64 | 0,76 | 22 | 1408 | 113 | 226 | 74 |
| | 46 | 64 | 0,69 | 22 | 1408 | 144 | 288 | 136 |
| | 47 | 32 | 0,92 | 22 | 704 | 76 | 76 | 76 |
| | 48 | 32 | 0,81 | 22 | 704 | 96 | 96 | 20 |
| | 49 | 32 | 0,76 | 22 | 704 | 113 | 113 | 37 |
| | 50 | 32 | 0,69 | 22 | 704 | 144 | 144 | 68 |
| Total | 51 | | | | | | 39969 | 21045 |

# Fig. 13

| | ID | Z | CR | Kb | K | Connexions | Taille config | Taille config opt. |
|---|---|---|---|---|---|---|---|---|
| BG2 | 0 | 384 | 0,67 | 10 | 3840 | 67 | 804 | 804 |
| | 1 | 320 | 0,67 | 10 | 3200 | 67 | 670 | 670 |
| | 2 | 320 | 0,50 | 10 | 3200 | 77 | 770 | 100 |
| | 3 | 320 | 0,33 | 10 | 3200 | 121 | 1210 | 540 |
| | 4 | 256 | 0,67 | 10 | 2560 | 67 | 536 | 536 |
| | 5 | 256 | 0,50 | 10 | 2560 | 77 | 616 | 80 |
| | 6 | 256 | 0,33 | 10 | 2560 | 121 | 968 | 432 |
| | 7 | 256 | 0,20 | 10 | 2560 | 197 | 1576 | 1040 |
| | 8 | 192 | 0,67 | 10 | 1920 | 67 | 402 | 402 |
| | 9 | 192 | 0,50 | 10 | 1920 | 77 | 462 | 60 |
| | 10 | 192 | 0,33 | 10 | 1920 | 121 | 726 | 324 |
| | 11 | 192 | 0,20 | 10 | 1920 | 197 | 1182 | 780 |
| | 12 | 128 | 0,67 | 10 | 1280 | 67 | 268 | 268 |
| | 13 | 128 | 0,50 | 10 | 1280 | 77 | 308 | 40 |
| | 14 | 128 | 0,33 | 10 | 1280 | 121 | 484 | 216 |
| | 15 | 128 | 0,20 | 10 | 1280 | 197 | 788 | 520 |
| | 16 | 64 | 0,67 | 10 | 640 | 67 | 134 | 134 |
| | 17 | 64 | 0,50 | 10 | 640 | 77 | 154 | 20 |
| | 18 | 64 | 0,33 | 10 | 640 | 121 | 242 | 108 |
| | 19 | 64 | 0,20 | 10 | 640 | 197 | 394 | 260 |
| Total | 20 | | | | | | 12694 | 7334 |

**Fig. 14**

EP 4 595 233 B1

Fig. 15

EP 4 595 233 B1

Fig. 16

Distribution des degrés des noeuds de contrôle pour BG1 et BG2 après réordonnancement, pour le taux de codage minimal

**Fig. 17**

EP 4 595 233 B1

Distribution des degrés des noeuds de contrôle pour BG1 et BG2 après réordonnancement, pour un taux de codage R = 1/2

**Fig. 18**

Fig. 19

**Fig. 20**

**Fig. 21**

EP 4 595 233 B1

31, 31-c

Décodeur LDPC

23

Ord. niv. 2

21

Ord. niv. 1

Cœur LDPC — 10

Cœur LDPC

20 — Mem. niv. 1

Cœur LDPC

Cœur LDPC

21

Ord. niv. 1

Cœur LDPC — 10

Cœur LDPC

20 — Mem. niv. 1

Cœur LDPC

Cœur LDPC

22

Mem. niv. 2

21

Ord. niv. 1

Cœur LDPC — 10

Cœur LDPC

20 — Mem. niv. 1

Cœur LDPC

Cœur LDPC

21

Ord. niv. 1

Cœur LDPC — 10

Cœur LDPC

20 — Mem. niv. 1

Cœur LDPC

Cœur LDPC

# Fig. 22

## RÉFÉRENCES CITÉES DANS LA DESCRIPTION

**Documents brevets cités dans la description**

- US 2022182076 A1
- EP 3331180 B1
- EP 2369749 A2
- US 11108410 B1

**Littérature non-brevet citée dans la description**

- **FOMINYKH A.** *Comparative Analysis of Polar and LDPC Codes in Space and Satellite Communication Systems*
- **ZHAO QIANGYI**. *Design of a Multi-Core Scheduling Scheme for Tera-bit/s LDPC Decoding*
- **SIN-YU SHIH**. *A real-time programmable LDPC decoder chip for arbitrary QC-LDPC parity check matrices*
- **JIN ZUOLIN**. *Low Latency MCS Design for LEO Satellite Communication Based on 5G*
- **ZHAO QIANGYI**. *Design of a Multi-Core Scheduling Scheme for Tera-bits/s LDPC Decoding*